# EUROPEAN PATENT SPECIFICATION

(11) **EP 3 997 254 B1**
(45) Date of publication and mention of the grant of the patent: **21.06.2023**
(21) Application number: 20740437.7
(22) Date of filing: 10.07.2020
(51) Int. Cl.: C23C 14/00, C23C 14/06, C23C 14/32, C23C 28/04, C23C 30/00, C23C 14/34

(54) **SAW BLADE OR OTHER CUTTING TOOL COMPRISING A COATING**
SÄGEBLATT ODER ANDERES SCHNEIDWERKZEUG MIT EINER BESCHICHTUNG
LAME DE SCIE OU AUTRE OUTIL DE COUPE COMPRENANT UN REVÊTEMENT

(30) Priority: 11.07.2019 US 201962872763 P; 11.07.2019 NL 2023484; 11.07.2019 NL 2023485
(43) Date of publication of application: 18.05.2022
(73) Proprietor: Knight Acquisition B.V., 6905 DL Zevenaar (NL)
(72) Inventor: SCHRÖDER, Werner, 6905 DL Zevenaar (NL)
(74) Representative: EDP Patent Attorneys B.V.
(86) International application number: PCT/NL2020/050461
(87) International publication number: WO 2021/006739

(56) References cited:
- JP-A- 2007 144 595
- JP-A- 2007 313 582
- US-A1- 2004 237 840
- US-A1- 2006 269 788

## Description

### FIELD OF THE INVENTION

The invention relates to an article, especially a cutting tool, comprising a coating, a method for providing a coating at an article, and a (tribological) coating per se.

### BACKGROUND OF THE INVENTION

Cutting tools comprising a wear resistance coating are known in the art. EP 3228726 describes, e.g., a coated cutting tool comprising a body and a coating deposited by PVD on the body, wherein the body comprises cemented carbide, cermet, ceramics, polycrystalline diamond, polycrystalline cubic boron nitride based materials or a high speed steel, and wherein the coating comprises a first layer of (Ti₁₋ₓAlₓ)N where 0.3≤x≤0.7, and a second layer of (Ti_{1-p-q}AlₚSi_{q})N where 0.15≤p≤0.45, and 0.05≤q≤0.20, wherein the second layer is deposited outside the first layer as seen in a direction from the body.

US2002/0168552 describes a hard film for cutting tools which is composed of (Ti_{1-a-b-c-d}, Alₐ, Cr_{b}, Si_{c}, B_{d}) (C₁₋ₑNₑ) 0.5≤a≤0.8, 0.06<b, 0≤c≤0.1, 0≤d≤0.1, 0≤c+d≤0.1, a+b+c+d<1, 0.5≤e≤1 (where a, b, c, and d denote respectively the atomic ratios Al, Cr, Si, and B, and e denotes the atomic ratio of N.) Further, also US2004/237840 describes a hard film for cutting tools which is composed of (Ti_{1-a-b-c-d}, Alₐ, Cr_{b}, Si_{c}, B_{d}) (C₁₋ₑNₑ); with 0.5≤a≤0.8, 0.06≤b, 0≤c≤0.1, 0≤d≤0.1, 0≤c+d≤0.1, a+b+c+d<1, 0.5≤e≤1 (where a, b, c, and d denote respectively the atomic ratios Al, Cr, Si, and B, and e denotes the atomic ratio of N.)

JP2007313582 describes a surface-coated cutting tool, with a hard coating layer comprising (a) a bottom layer having average layer thickness of 1-5 µm, and made of a composite nitride layer of Ti, Al, Si and Cr satisfying a composition formula:(Ti_{1-x-y-z}AlₓSi_{y}Cr_{z})N (where X denotes 0.30-0.70, Y denotes 0.01-0.10 and Z denotes 0.01-0.15 in an atomic ratio), and (b) a top layer made of an alternating laminate structure of vanadium nitride layers and vanadium oxide layers having average layer thickness of 0.4-2 µm, having vanadium oxynitride layers with average layer thickness of 0.02-0.2 µm between the respective layers, and having overall average layer thickness of 1-5 µm, is formed on a surface of a tool base made of a tungsten carbide base cemented carbide or a titanium nitride base cermet.

JP2007144595 describes a surface coated cutting tool. The hard coating layer including the followings (a) to (c) formed on the surface of a tool base made of tungsten carbide-base cemented carbide or a titanium carbide nitride-base cermet, (a) a lower layer made of a composite nitride layer of Ti, Al, Si and Cr having the average layer thickness of 1 to 5 µm and satisfying the composition formula (Ti_{1-x-y-z}AlₓSi_{y}Cr_{z})N (wherein X indicates 0.30 to 0.70, Y indicates 0.01 to 0.10, and Z indicates 0.01 to 0.15 by atomic ratio), (b) an interlayer adhesion layer made of vanadium nitride layer having the average layer thickness of 0.1 to 1.5 µm. (c) an upper layer having an alternately stacking structure of a vanadium nitride layer and a vanadium oxide layer having an average layer thickness of 0.1 to 1 µm per layer and having the total average layer thickness of 1 to 5 µm.

### SUMMARY OF THE INVENTION

Cutting, drilling, and milling tools often comprise a protective coating. The coating is provided for protecting the tool material (substrate or body) against mechanical, thermal and chemical loads. The coating is, e.g., applied for extending the tool life and/or minimize the friction during tooling, which again may extend the tool life; and at the same time may reduce the cutting force needed. Coatings may be used to improve tribological properties, such as friction and wear of tools for cutting and (metal) forming and may also be used to improve properties of machine elements e.g. sliding bearings, seals and valves. Such coatings, especially improving properties of an article that is relatively moved to a further element, may also be called "tribological coatings". Tribological coatings may be relatively thin (e.g. up to 10 or 20 µm, or even less) such that still the substrate material may play a role in friction and wear performance. Tribological coatings, further referred to as "coatings" may be provided to a substrate by means of chemical vapor deposition or physical vapor deposition.

These coatings are also classified as gaseous coatings, as the deposited material is applied from the gas phase. The required properties of a coating may be determined by the tooling conditions such as tool speed, material to be tooled, temperature, cutting geometry, et cetera. Especially, the material to be tooled, the speed of the tool and a relative movement of the material with respect to the tool may be most relevant factors for the wear of the tool and the resulting temperature at the tool surface.

The coating may be configured for counter acting this wear, by means of providing a hard protection cover, which has a lower wear rate than the substrate; providing a thermal barrier, for lowering the temperature rise of the substrate; providing a chemical barrier, for minimizing the exchange of components between the substrate and the metal being cut; lowering the friction coefficient with the work piece, for lowering the frictional forces during tooling, which on its turn will lead to less heat being generated and a lower wear rate.

In cutting tools, thin hard coatings on softer, tough substrates have often resulted in the extension of tool life of ten times and more. Various coating structures have been developed throughout the years. The simplest coating structure is called a monolithic structure, especially comprising a single functional layer. Many different coatings are known in the art having many different compositions and substructure. The first-generation titanium nitride (TiN), titanium carbonitride (TiCN) and zirconium nitride (ZrN), as well as later developed titanium aluminum nitride (TiAlN) and aluminum chromium nitride (AlCrN) coating layers and nanostructured layers are all referred to as monolithic coatings.

Multilayer coatings are also known and consist of a combination of monolithic coatings that essentially differ in functionality, i.e. one layer type especially increasing the hardness, while the other layer may lower the friction coefficient. These various layers are commonly bound together by an interlayer to improve the adhesion of the two layers, and to prevent crack propagation in a direction of the substrate. Nanocomposite structures may comprise a mixture of various components in a single layer.

Normally, the substrate is first covered by an interface (or base) layer to improve the adherence of the coating structure on the substrate. A top layer often finishes the structure. A top layer may e.g. be configured for having a lower friction coefficient that the functional layer, so that at the start of the tooling a more even wear may be obtained.

Herein, the coating may further be explained based on a (circular) saw blade comprising the coating. It is however noted that the coating may be a functional coating e.g. to improve wear and/or to lower friction, that may be provided to all kinds of tools or machine parts. The coating may, e.g., be provided to a cutting tool, a drilling tool, or a milling tool. Hence, the tool of the invention comprising such coating may, e.g., be a (circular) saw blade, a tool bit, a router bit, a drill, etc.. Such tool may at least partly be covered by the coating.

As discussed above, different coatings are known that may be applied to different kinds of tools or machine parts.

In the table below, some coating substructure compositions for cutting tools are listed with their respective properties:

| Substructure composition | Hardness [HV] | Friction coefficient [-] | Maximum temperature [°C] |
|---|---|---|---|
| TiN | 2500 | 0.55 | 600 |
| TiCN | 3200 | 0.2 | 400 |
| TiAlN | 2950 | 0.6 | 700 |
| AlTiN | 3200 | 0.7 | 900 |
| TiAlCN | 2900 | 0.3 | 500 |
| CrN | 2000 | 0.3 | 700 |
| CrCN | 2200 | 0.25 | 600 |
| AlCrTiN | 3000 | 0.4 - 0.6 | 50 |
| AlTiN/Si3N4 | > 3000 | 0.45 | 1200 |
| AlCrN/Si3N4 | > 2900 | 0.35 | 1100 |
| WCC | 1000 - 2200 | 0.2 - 0.25 | 400 |
| ZrC | 3100 | 0.5 | 600 |
| ZrN | 2400 | 0.4 | 550 |

Preferably, the coating has a high hardness, a low friction coefficient and is stable at very high temperatures. The harder the coating, the lower the wear will be. Especially, when cutting high tensile strength steels, hard coatings may be needed. The temperature rise during cutting may especially determine whether the coating will hold its properties. At high cutting speeds, insufficient cooling (directly or via the material that is cut) may result in a high temperature of (the surface of) the tool. Coatings with a relatively low temperature stability may then not hold their properties. A low friction coefficient may help to prevent the temperature rise to a certain extent, acting as a lubricant.

Since decades studies have been focusing on improving (the tribological properties of) the coating. Yet, still many coatings seem to suffer from high friction and/or high wear. Articles and tools having the coatings already may show cracks or loose part of the coating after a limited period of operation. Today still the tooling branch is further looking for higher productivity and more efficient production. Therefore, there is still a need for further improved coatings that may be applied for a longer period and/or at higher speeds and as such may lower the downtime and/or increase the productivity.

Hence, it is an aspect of the invention to provide an alternative article, especially an alternative (cutting) tool, comprising a coating, which preferably further at least partly obviates one or more of above-described drawbacks. Moreover it is an object of the invention to provide a (tribological) coating, especially the coating comprised by the article, which preferably further at least partly obviates one or more above described drawback. The invention further provides a method for providing a (tribological) coating, especially the coating of the invention, on a substrate, especially of a cutting tool, which preferably further at least partly obviates one or more of above-described drawbacks.

The present invention may have as object to overcome or ameliorate at least one of the disadvantages of the prior art, or to provide a useful alternative.

The coating of the invention may show less wear after use compared to prior art solutions. The coating (and article) may have a longer (tool) life. The coating may provide a lower friction when being used. The material being tooled may (therefore) heat up in a lesser extend compared to prior art solutions. The article/tool comprising the coating may be used for an extended period before it needs replacement compared to prior art tools. The tool may allow tooling at higher speeds compared to prior art tools. Hence, the article and/or tool may improve productivity and efficiency and may lower times required to change the tool.

Therefore, in a first aspect, the invention provides an article, especially a (cutting) tool, comprising a coating (on a substrate), wherein the coating comprises a first layer element, wherein the first layer element has an overall composition comprising (substantially consisting of) the metal (and/or metalloid) elements aluminum, chromium, titanium, and silicon as further defined in the accompanying claims. The first layer element comprises one or more (stacked), especially a number N_{lay} of, first layer element layers. Further, each of the first layer element layers comprises (or is) a nitride layer. Further, N_{lay} is at least 2. Further, each of the first layer element layers is a nitride layer of the metal and metalloid elements aluminum, chromium, titanium, and silicon. Especially, each of the first layer element layers is a nitride layer of (substantially only) the metal and/or metalloid elements aluminum, chromium, titanium and silicon. The N_{lay} (stacked) first layer element layers comprise at least two different types of layers, wherein the different types of layers at least differ in a silicon content, especially wherein a first type of the (different) layers has a highest silicon content C_{Si,H}, (expressed in at.%) relative to a total of the metal and the metalloid elements (in the first type of the layers), and wherein a second type of the (different) layers has a lowest silicon content C_{Si,L} (expressed in at.%), relative to a total of the metal and the metalloid elements (in the second type of the layers). Further, a ratio of the lowest silicon content C_{Si,L} to the highest silicon content C_{Si,H} is selected from the range of 0.25≤C_{Si,L}/C_{Si,H}≤0.9.

The coating is especially a tribological coating.

In a further aspect, the invention provides the coating (on a substrate) per se.

The term "substrate" may especially relate to a body of the article and/or tool comprising the coating. The substrate may thus comprise characteristics configured for the (final) article. The substrate may e.g. comprise an uncoated (part of a) (roller) bearing or an uncoated drill bit. The substrate may comprise an (uncoated) tool, such as an uncoated (circular) saw blade. The substrate may comprise an uncoated tooth, tip or insert of a saw blade to be coated. The coating may in embodiments comprise a thickness in the micrometer range. A total coating thickness of the coating may in embodiments, e.g., be selected from the range of 1.5-12 µm, especially from the range of 3-8 µm (see further below).

Therefore, dimensions of the substrate especially substantially are the same as dimensions of the (final) article/tool. Furthermore, the substrate may comprise (a material comprising) cemented carbide such as tungsten carbide, titanium carbide, or tantalum carbide. In further embodiments, the substrate may comprise high speed steel. The dimensions and the material of the substrate are especially selected for providing the article/tool.

Hence, in embodiments, the (article or) tool is a cutting tool, such as a saw blade, a tool bit, a router bit or a drill. Especially, the cutting tool is a (circular) saw blade. The cutting tool may in further embodiments be a tooth or an insert or a tip of a sawblade, especially of a circular saw blade. The cutting tool may be a tungsten carbide tipped cutting tool.

Hence, in embodiments, the first layer element comprises (consist of) one first element layer. In specific embodiments, the first layer element comprises a plurality of first layer element layers. In a further embodiment, the first layer element layer comprises a number N_{lay} of first layer element layers. The plurality of first layer element layers are especially configured on top of (and contacting) each other, i.e. in a stacked configuration, especially wherein the respective (successive) layers at least partly cover each other. If the first layer element, for example, comprises N_{lay} first layer element layers, the 2^{nd} first layer element layer may be configured at (and contacting) the 1^{st} first layer element layer, and especially at least partly covering the 1^{st} first layer element layer; the 3^{rd} first layer element layer (if present) may be configured at (and contacting) the 2^{nd} first layer element layer, and especially at least partly covering the 2^{nd} first layer element layer; ... , and the N_{lay}^{th} first layer element layer may be configured at (and contacting) the N_{lay}-1^{th} first layer element layer, and (especially) at least partly covering the N_{lay}-1^{th} first layer element layer.

Herein the term first layer element layer may relate to a plurality of (different) first layer element layers. Also the terms "base layer element layer", "top layer element layer", "intermediate layer element layer", and optional other layer element(s) (layer) may relate to a plurality of (different) base layer element layers, (different) top layer element layers, and (different) intermediate layer element layer, and optional other layer element (layer), respectively (see further below).

The first layer element has an overall composition comprising the elements aluminum, chromium, titanium, and silicon, herein also indicates as "Al", "Cr", "Ti", and "Si", respectively. In specific embodiments (also) each of the first layer element layers comprises the metal elements aluminum, chromium, titanium, and silicon.

Silicon may commonly be recognized as a metalloid. Yet, silicon (Si) may also be recognized as a metal element. Herein, Si may be indicated as a metal element for clarity reasons. Thus, the term "metal element" may also refer to metal elements and metalloid elements. Especially, the phrase "the metal elements Al, Cr, Ti, and Si" and comparable phrases may also refer to "the metal elements Al, Cr and Ti, and the metalloid element Si". Especially, herein the term "metal element" may refer to a combination (total) of the metal elements and the metalloid elements.

Hence, the first layer element comprises the metal elements Al, Cr, Ti, and Si. Al, Cr, Ti, and Si are not necessarily the only metal (and/or metalloid) elements in the first layer element (or in the first layer element layer(s)). The first layer element (layer(s)) may comprise a (small) amount of other metal elements and/or metalloid elements. Such as at maximum 10 at.%, especially at maximum 5 at.%, even more especially at maximum 1 at.%, such as at maximum 0.5 at.%, or at maximum 0.1 at.% (1000 ppm), of the total of the metal elements (and metalloid elements) (of the first layer element layer). In embodiments, the first layer element (layer(s)) may comprise impurities, such as other metal elements (or metalloid elements) in the range of a few ppm or even a few ppb to 10000 ppm (of the total of the metal elements (and metalloid elements).

In the first layer element (layer(s)), the metals may primarily be present as nitrides. The terms "nitrides" are especially related to compounds comprising the nitride anion and one or more of the cations of the metal elements (or metalloid element). The anions and cations may form different complexes and/or crystal structures. The nitrogen/nitride content is preferably close to stoichiometric but may vary in the range of about 80%-110% from stoichiometry. Yet, at least a part of the nitrogen may be present not bound to the metal elements, especially at high operating pressures. This unbound nitrogen is generally assumed to have a negative effect on the properties of the coating. Preferably less than 1 at.% of nitrogen present in the coating is not bound to a metal element.

The layers may e.g. additionally comprise some carbon and/or oxygen, e.g. in concentrations between 0 and 2 at.%. Herein, the "names" of the layers referred to may be based on the composition of the compounds. Hence, if a nitride layer substantially consists of the metal elements metal 1 (M1), metal 2 (M2),.., and metal n (Mn), the layer may be referred to as a "metal 1 metal 2 ... metal n nitride" layer or (M1 M2...Mn)N layer. Thus, the nitride layer comprising the elements Al, Ti, Cr, and Si, may be referred to as an aluminum chromium titanium silicon nitride/(AlCrTiSi)N layer. Moreover, such layers may (also) be referred to as a nitride layer comprising AlCrTiSi. Likewise, an aluminum titanium nitride layer refers to a nitride layer comprising substantially only the metal elements aluminum and titanium. Such layer may also be indicated as (AlTi)N.

Moreover, some of the layer elements of the coating, especially the top layer element, (see below) may comprise a carbonitride layer. Also carbonitride may form complexes with the metal elements, e.g., comparable to nitride. Hence, a layer may be referred to as a "metal 1 metal 2 ... metal n carbonitride" layer or ((M1 M2...Mn)CN or) if a carbonitride layer substantially consists of the metal elements metal 1 (M1), metal 2 (M2),.., and metal n (Mn).

The first layer element comprises a nitride layer of AlCrTiSi. The content of the different metal elements relative to each other may further be indicated by subscripts, such as in the next formulas AlₐCr_{b}Ti_{c}Si_{d} and (AlₐCr_{b}Ti_{c}Si_{d})N. In such notation the subscripts indicate the fractions or ratios of a specific metal element (atoms) relative to the total metal elements (atoms). Such notation is known to the person skilled in the art.

Moreover, the phrase "wherein the first layer element has an overall composition comprising the metal elements (and/or metalloid elements) aluminum, chromium, titanium, and silicon" may relate to the first layer element comprising (AlₐCr_{b}Ti_{c}Si_{d})N. The phrase may especially relate to the first layer element substantially (e.g. for at least 99 at.%, especially at least 99.5 at.%) consisting of (AlₐCr_{b}Ti_{c}Si_{d})N. A phrase like (in the first layer element,) the aluminum is available with at least 68 at.% relative to a total of the metal elements, wherein (in the first layer element) silicon is available in the range of 0.5-2 at.% relative to the total of the metal elements may thus also be formulated as the first layer element comprising (or substantially consisting of) (AlₐCr_{b}Ti_{c}Si_{d})N, wherein a ≥ 0.68 and 0.005≤d≤0.02

Hence, in specific embodiments, the first layer element comprises (AlₐCr_{b}Ti_{c}Si_{d})N, wherein a ≥ 0.72. In further embodiments, the first layer element comprises (AlₐCr_{b}Ti_{c}Si_{d})N, wherein 0.007≤d≤0.0017.

Furthermore, because additional metal elements are not excluded (in the first layer element) a+b+c+d ≤1 (in the first layer element), especially a+b+c+d is at least 0.9, especially at least 0.95, even more especially at least 0.99, such as at least 0.995.

Herein the term "at.%" or atomic percent is used. The atomic percent (normally) gives the percentage of one kind of atom relative to the total number of atoms. Herein, the atomic percent (at.%) is especially used in relation to the metal elements (only). The at.% as used herein especially refers to the percentage of atoms of the respective metal element relative to the total metal elements in the respective element concerned. For instance, if the concerned element is the first layer element and it is described that "the first layer element comprises (or has available) 70 at.% of aluminum", this especially refers to the fact that the first layer element comprises 70 atoms of the specific metal element per every 100 atoms of all metal (and metalloid) atoms (including aluminum) in the first layer element. For instance, if it is described herein that the first layer element layer comprises a nitride layer comprising (the metal elements) aluminum, titanium, chromium and silicon, wherein the first layer element layer comprises at least 70 at.% aluminum (or wherein aluminum is available with at least 70 at.%) (relative to the total of metal elements (or a total of metal and metalloid elements)) than at least 70% of the total of the metal (and metalloid) atoms (of aluminum, titanium, chromium, and silicon, and optionally any further metal/metalloid element) are aluminum atoms (irrespectively of the number of nitrogen atoms in the first layer element layer).

Herein, also the term "content" is used. That term may especially also refer to a number of atoms or ions (of the respective metal) relative to a total number of atoms, elements or ions etc., (especially referring to at.%) and thus being independent from a size or thickness of the layer or a weight of any of the other metal elements. The content may be expressed in at.%, and especially relative to the total of metal elements.

In further embodiments, aluminum is available in the first layer element (layer(s)) with at least 72 at.%, more especially at least 72.5 at.% (relative to the total of metal elements available in the first layer element layer(s)). Especially, aluminum is available in the first layer element (layer(s)) with equal to or less than 77 at.%, such as equal to or less than 75 at.% (relative to the total of metal elements available in the first layer element layer(s)). In embodiments, aluminium is available in the first layer element (layer(s)) in the range of 72.5-75 at% (relative to the total of metal elements and metalloid elements available in the first layer element layer(s)).

Hence, in further embodiments, the first layer element (layer(s)) comprises (the) (AlₐCr_{b}Ti_{c}Si_{d})N, wherein a ≥ 0.72. especially ≥0.725, and especially a≤≤0.77, such as ≤0.75.

Hence, especially aluminum is available in the first layer element with a maximum of 77 at.% relative to the total of the metal elements.

Titanium may further especially be available in the first layer element, especially in the first layer element layer(s), with at least 5 at.%, relative to the total of the metal elements. Hence, in embodiments, c ≥ 0.05 in (the) (AlₐCr_{b}Ti_{c}Si_{d})N of the first layer element (layer(s)). In further embodiments c≥0.05, such as ≥ 0.07, especially ≥ 0.08 in (AlₐCr_{b}Ti_{c}Si_{d})N of the first layer element (layer(s)). The content of titanium in the first layer element (layers(s)) is especially equal to or lower than 11 at.% (relative to the total of the metal elements in the first layer element (layer(s))). Hence, in further embodiments, the first layer element (layer(s)) comprise (the) (AlₐCr_{b}Ti_{c}Si_{d})N, wherein c ≤0.11; such as 0.05≤c≤0.11, or 0.08≤c≤0.11.

In further embodiments, chromium is available in the first layer element with a maximum of 20 at.%, such as equal to or less than 18 at.% relative to the total of the metal elements. The first layer element (layers(s)) may further comprise at least 13 at.% chromium. Hence, chromium may be available in the first layer element (layer(s)) with an atomic percent selected from the range of 13-20 at.%, or even 13-18 at.%.

Hence, in further embodiments, the first layer element (layer(s)) comprises (the) (AlₐCr_{b}Ti_{c}Si_{d})N, wherein b≤0.20, such as ≤0.18. The first layer element (layer(s)) may especially comprises (the) (AlₐCr_{b}Ti_{c}Si_{d})N, wherein b ≥ 0.13. such as 0.13≤b≤0.2.

The presence of silicon in the first layer element (layer(s)) may provide an improved wear resistance of the coating. Yet, experimentally it was observed than under a minimum content of silicon no significant effect may be shown. Furthermore, also silicon contents higher than a specific maximum silicon content did not seem to have a positive effect or even could in embodiments have a negative effect on the wear characteristics of the coating. Preferably, silicon is available with at least 0.7 at.% in the first layer element (relative to the total of the metal elements in the first layer element). Moreover, in specific embodiments, silicon is available in the first layer element) at a maximum of 1.7 at.%, or even at maximum 1.5 at.% (relative to the total of the metal elements in the first layer element). Silicon atoms may not associate with the other metal /metalloid elements and may form segregated silicon (nitride) regions. Especially, at silicon concentrations of 2 at.% or more, this may reduce the coating properties. At higher Si amounts, the structure of the coating may change. Furthermore, it is hypothesized that only very small amounts of silicon are required. The silicon-rich regions may eventually migrate in the coating during wear of the surface of the coating. Hence, the first layer element especially comprises at least 0.7 at.% Si, such as selected from the range of 0.7-1.7 at.%, such as in the range of 0.7-1.5 at.%. Especially, also the silicon content (in at.%) in the first layer element layer (s) may be in the ranges described (above) in relation to the first layer element. In embodiments, the silicon content in the first layer element (layer(s)) may be about 1 at.% relative to the total metal (and metalloid) elements). Yet, in specific embodiments the silicon content (in at.%) in at least one of the first layer element layers may be higher than the values described in relation to the first layer element. In further embodiments at least one of the first layer element layers may be lower than the values described in relation to the first layer element (but especially larger than 0 at.%, such as at least 0.25 at%). The (overall) silicon content in the first layer element is especially in the range of 0.7-1.7 at.%, especially 0.7-1.5 at.%. In embodiments, the (overall) silicon content in the first layer element is 1±0.25 at.%.

Hence, in further embodiments, the first layer element (layer(s)) comprises (the) (AlₐCr_{b}Ti_{c}Si_{d})N, wherein d≤0.017. The first layer element (layer(s)) may especially comprises (the) (AlₐCr_{b}Ti_{c}Si_{d})N, wherein d≥0.007. such as 0 0.007≤d≤0.017. In embodiments, 0.007≤d≤ 0.015.

The above described embodiments depicting the different percentages may especially be combined. For instance, in an embodiment, the first layer element (layer(s)) comprise (AlₐCr_{b}Ti_{c}Si_{d})N, wherein 0.72≤a≤0.77, 0.13≤b≤0.2, 0.05≤c≤11, and 0.07≤d≤0.017. Especially, with such composition provided durable coatings have been produced

In the first layer element (layer(s)), aluminum is available in the range of 72-77 at.%, titanium is available in the range of 5-11 at.%, chromium is available in the range of 13-20 at.%, and silicon is available in the range of 0.7-1.7 at.%, especially in the range of 0.7-1.5 at.% (wherein all at.% are defined relative to the total of the metal and metalloid elements in the first layer element (layer(s))). Hence, it may be understood that in such embodiment 72-77 percent of the metal atoms Al, Cr, Ti, and Si (plus any optional further metal atoms) in the first layer element (layer(s)) are aluminum atoms. It further will be understood that a total of aluminum, chromium, titanium and silicon available in the first layer element layer(s)) is equal to or less than 100 at.%. In embodiments, the total of the metal elements chromium and titanium may be available in the range of about 20-30 at.%, especially 21-27 at.%, even more especially 22-26 at.%, in the first layer element (layer(s)). The first layer element is especially a functional layer element, especially improving the durability of the coating.

In further embodiments, the coating may comprise further layer elements. The coating may, e.g., comprise a base layer element arranged between the substrate and the first layer element, and may be configured for adhering the first layer element to the substrate. Additionally or alternatively, the coating may comprise a top layer element, arranged over, especially covering, the first layer element, especially at an exterior side of the article and/or (cutting) tool. The top layer element may especially be configured for lowering the friction between the article (tool) and a material contacting the article (tool), such as a material being cut by a cutting tool. The top layer element may especially comprise carbon to lower the friction coefficient. In further embodiments, the top layer element is configured for allowing a recoating of the article/tool and/or to increase chemical resistance of the article. These different layer elements may comprise (only) one respective layer element layer. Yet, at least one of these different layers, especially both layer elements, may in embodiments comprise a plurality of (stacked) respective layer elements layers. Hence, in embodiments, at least one of the top layer element layers comprises a carbonitride layer. The top layer element layer(s) may further comprise a nitride layer. Moreover, in embodiments, at least the top layer element layer configured most remote from the substrate may comprise a nitride layer (configured for enabling recoating).

To further improve the adherence between the substrate and the first layer element, the composition of the base layer element layers may (gradually) (layer-by-layer) change in the base layer element in a direction from the substrate to the first layer element. The (composition of the) base layer element layer configured contacting the substrate may be selected for a good adherence to the substrate. The (composition of the) base layer element layer contacting the first layer element may be configured for a good adherence to the first layer element. In the base layer element, especially the aluminum content (as expressed in at.%) may increase in successive layers (in the direction form the substrate to the first element layer) of the base layer element.

Therefore, in further embodiments, an aluminum content of an upper base layer element layer configured closest to, especially contacting, the first layer element, is higher than the aluminum content in a lower base layer element layer configured closest to, especially contacting, the substrate. Like for the other contents, the aluminum content is especially expressed in at.% (relative to the total of metal elements in the respective base layer element layer) (see also above).

Hence, in embodiments, the coating further comprises (i) a base layer element arranged between the substrate and the first layer element and/or (ii) a top layer element arranged over (covering) a the first layer element (at an exterior side of the article /tool), wherein the base layer element comprises one or more base layer element layers, especially wherein any one of the base layer element layers comprises a nitride layer comprise chromium nitride and/or aluminum-chromium-nitride, and wherein the top layer element comprises one or more top layer element layers, especially wherein any one of the top layer element layers comprises (i) a nitride layer comprising chromium and/or aluminum, such as CrN and/or (AlCr)N or (ii) a carbonitride layer comprising chromium and/or aluminum, such as CrCN and/or (AlCr)CN.

The base layer element may further comprise a base layer element thickness (of the base layer element) selected from the range of 0.1-2 µm, such as 0.2-1.2 µm. The top layer element may comprise a top layer element thickness (of the top layer element) selected from the range of 0.1-2 µm, such as 0.2-1.2 µm. In embodiments, a thickness of the first layer element may be selected from the range of 1-12 µm, especially from the range of 2-7 µm. In further embodiments, the thickness of the first layer element is selected from the range of 1-5 µm. In further embodiments, the thickness of the first layer element is 4-10 µm.

In further embodiments, a total coating thickness of the coating (including -if present- any base layer element, top layer element, intermediate layer element or further layer element) may be selected from the range of 1.5-12 µm, such as 3-10 µm, especially 3-8 µm.

Herein also the term "functional layer (element)" may be used in relation to the first layer element (layer). Yet, in embodiments, the coating may comprise at least one further functional layer (element). It will be understood that the coating may also further comprise (any) further layer. The further (functional) layer may be arranged between the first layer element and the substrate. Additionally or alternatively, the further (functional) layer may be arranged further remote from the substrate than the first layer element, such as between the first layer element and the top layer element. The further (functional) layer essentially has another composition than the first layer element layer(s)). The further (functional) layer may, e.g., not comprise all metal elements from the group of Al, Ti, Cr, and Si, or the content of said elements may differ from the contents of these elements in the embodiments of the first layer element as described herein. The further (functional) layer may comprise further metal elements and/or further non-metal elements.

In yet further embodiments, the coating may comprise more than one first layer element, especially wherein an intermediate layer element is configured between (at least two) successive first layer elements. The coating may comprise, e.g., two, three, four, six or ten first layer elements. The coating may comprise even more first layer elements. At least a part of the plurality of first elements are especially configured sandwiching an intermediate layer element. The different first layer elements may differ from each other, e.g., in thickness and composition. Hence, the term first layer element may relate to a plurality of (different) first layer elements.

The intermediate layer element may thus (also) comprise the further (functional) layer. Additionally or alternatively, the intermediate layer element comprises an intermediate layer element layer comprising a nitride layer (i.e. an "intermediate layer element nitride layer") of one or more of the metal elements described herein. The intermediate layer element layer may especially substantially not comprise silicon. The intermediate layer element layer may e.g. comprise less than 0.01 at.% of the metal element silicon, relative to the total of the metal elements in the intermediate layer element layer. Yet in embodiments, the intermediate layer element may comprise silicon (especially wherein the intermediate layer element layer(s) is a further (functional) layer).

The intermediate layer element (layer(s)) may e.g. comprise one or more of (AlTiCr)N, (AlTi)N, (AlCr)N. In other embodiments, the intermediate layer element (layer) may comprise (TiCr)N. The intermediate layer element layer may further comprise other metal elements such as V, Co, Zr, W, Ta, Mo, Cu. The intermediate layer may in embodiments comprise a carbonitride layer. The intermediate layer element layer may be rather thin. A thickness of the intermediate layer element may e.g. be selected from the range of 0.05-0.5 µm. In further embodiments, the intermediate layer element (layer) may comprise a thickness as described in relation with the first layer element (layer). Furthermore, the thickness of the first layer element layer may in embodiments have values as described in relation with the other types of layers / layer elements described herein (intermediate element (layer), the top element (layer), base element (layer)).

Hence, in a further embodiment, the coating comprises more than one first layer element, wherein an intermediate layer element is arranged between at least two of the first layer elements, wherein the intermediate layer element comprises an intermediate layer element layer, wherein the intermediate layer element layer comprises a nitride layer comprising one or more of the metal elements selected from the group consisting of aluminum, titanium and chromium, especially wherein the nitride layer comprises one or more of aluminum titanium nitride, chromium nitride and aluminum chromium nitride.

Experimentally, it was further found that coatings comprising a first layer element with a plurality of (stacked) first layer element layers, having different compositions may (further) positively affect the lifetime of the article, especially of the cutting tool. Yet, each of the different first layer element layers may (still) comprise the metal elements aluminum, chromium, titanium, and silicon. The ratio between the different metal elements (in the different first layer element layers) may be selected to be different in at least one of the first layer element layers compared to the other first layer element layer(s). The first layer element layers may therefore comprise at least two different types of first layer element layers, wherein the different types of first layer element layers have a different composition. The first layer element layers may in embodiments e.g. comprise three different types of first layer element layers, wherein the different types of first layer element layers have different compositions. In further embodiments, at least one of the subsets of the stacked subsets comprises at least three different types of first layer element layers.

The different types of first layer element layers may especially all comprise (AlₐCr_{b}Ti_{c}Si_{d})N. Especially, at least part of the fractions (of the different metal elements) (the subscripts) a, b, c, and d may in a first type of the different types of (first layer element) layers differs from the once of a second type of the different types of the layers. Especially, the content of silicon (or the value of the subscript d in the above given formulas) may be selected to differ in different types of the first layer element layers. In embodiment, each first layer element layer may differ in composition from the other first layer element layers. Therefore, the first layer element comprising N_{lay} first layer element layers, may especially comprise (two) up to N_{lay} different types of first layer element layers. In further embodiments the first layer element layer comprises 2-15, such as 2-10, especially 2-7, different types of first layer element layers. The first layer element may in embodiments comprises at least 3 different types of first layer element layers. The term "first type", "second type", or any "further type", etc. in relation with the different types of first layer element layers may especially relate to a plurality of the first type and/or the second type and/or the further type, etc. of the different types of first layer element layers.

The terms "tool life" and "lifetime" especially relate to a total time the article may be used (under normal conditions) before it is worn out (and must be replaced).

In further embodiments, arrangements or sets of two or more different types of first layer element layers may be provided in the first layer element, and especially the arrangements may be stacked to provide the first layer element. In embodiments, the first layer element may e.g. comprise repeating (stacked) subsets (or arrangements) of the first layer element layers.

Hence, in further embodiments, the first layer element comprises a plurality of first layer element layers, wherein any one of the first layer element layers comprises the metal elements aluminum, chromium, titanium, and silicon, and wherein the first layer element layers comprise at least two different types of layers, wherein the different types of the layer at least differ in a silicon content. A first type of the (different) layers may have a highest silicon content C_{Si,H} (in at.%) (relative to a total of the metal elements (in said layer)), and a second type of the (different) layers may have a lowest silicon content C_{Si,L} (in at.%) (relative to a total of the metal elements (in said layer)). In embodiments, a ratio of the lowest silicon content C_{Si,L} to the highest silicon content C_{Si,H} may, e.g., be selected from the range of 0.25≤C_{Si,L}/C_{Si,H}≤0.9. In further embodiments, the ratio C_{Si,L}/C_{Si,H} may be 0.4-0.6. The silicon content (C_{Si,L} and C_{Si,H}) is especially expressed herein in at.% (see further below). For instance, in an embodiment C_{Si,L} is 0.7 at.% and C_{Si,H} is 1.4 at.% and the ratio C_{Si,L}/C_{Si,H} equals 0.5.

In further embodiments, the plurality of first layer element layers comprises a number subs_{N} of (stacked) subsets of the first layer element layers, wherein subs_{N} is at least 2, and wherein at least 2, especially each, of the subsets comprises the first type of the (different) layers and the second type of the (different) layers. The first layer element may in embodiments consists only of subsets of the first layer element layers stacked on top of each other. In further embodiments, the first layer element comprises a combination of one or more first layer element layers and a number of stacked subsets of first layer element layers. Especially, the first layer element layers of a subset comprise (at least two) different silicon concentrations. In embodiments the first type of the layers and/or the second type of the layers of different subsets may comprise a different C_{Si,L} and/or C_{Si,H}. The term "lowest silicon content" and "highest silicon content" may relate to a plurality of (different) lowest silicon contents and highest silicon contents. In embodiments, an average silicon concentration in the subset of first layer element layers (relative to the total amount of metals and metalloids in the subset) is about 1 at% (especially 0.8-1.2 (at%).

A subset thickness of each of the subsets may be equal to or smaller than 0.5 µm. In further embodiments, the subset thickness of each of the subsets may be equal to or smaller than 1.5 µm, such as equal to or smaller than 1 µm, especially equal to or smaller than 0.7 µm. The subset thickness may especially be at least 0.1 µm, such as equal to or larger than 0.3 µm. In embodiments, the subset thickness is in the range 0.1-1 µm, such as 0.1-0.7 µm, or 0.3-0.7 µm. It appears that especially the last described embodiments may be advantageously by applied at some cutting tools.

It has been found that cutting tools having a plurality of (stacked) first layer element layers, may be less sensitive to wear. Additionally, it may be beneficial if the stacked first layer elements comprise (a number of) different compositions. It is hypothesized that the different layers may absorb different kinds of impact (in direction, temperature, friction, etc.) and may differ in their tendency to adhere to the material being cut and as such together may be less sensitive to wear. Herein the term "different" in relation to a layer, especially relates to layers having a different composition.

Hence, in a further specific embodiment, the invention provides the article or (cutting) tool comprising a coating (on a substrate), wherein the coating comprises a first layer element, wherein the first layer element has an overall composition comprising the metal elements aluminum, wherein the first layer element comprises a number N_{lay} of (stacked) first layer element layers, wherein N_{lay} is at least 2, wherein at least two, especially each, of the first layer element layers comprises a nitride layer comprising the metal elements aluminum, chromium, titanium, and silicon, especially wherein each of the first layer element layers comprise the metal elements aluminum, chromium, titanium and silicon, and wherein the N_{lay} (stacked) first layer element layers comprise at least two different types of layers, wherein the different types of layer at least differ in a silicon content, especially wherein a first type of the (different) layers has a highest silicon content C_{Si,H}, (at.%) relative to a total of the metal elements, and wherein a second type of the (different) layers has a lowest silicon content C_{Si,L} (at.%), relative to a total of the metal elements, especially wherein a ratio of the lowest silicon content C_{Si,L} to the highest silicon content C_{Si,H} is selected from the range of 0.25≤C_{Si,L}/C_{Si,H}≤0.9.

In a further aspect, the invention provides a method for producing a (cutting) tool comprising a coating, especially the coating described herein (by PVD), as further defined in the accompanying claims. The method especially comprises applying physical vapor deposition ("PVD") (techniques), more especially cathodic arc evaporation.

The method comprises providing a substrate into a vacuum chamber of a physical vapor deposition ("PVD") oven. The vacuum chamber may comprise a number Cat_{N} of metal cathodes. Such number may be any number, such as 1, 2, 3, 4, 10, 16, 20, 40, etc.. The number Cat_{N} is at least 3. Especially, the (number Cat_{N} of) metal cathodes (together) are configured for providing at least part of the desired coating. Moreover, especially at least a subset (of the number Cat_{N}) of cathodes may be configured for providing the first layer element. Hence, in embodiments, at least a subset of the number Cat_{N} of metal cathodes together comprise the metal elements aluminum, chromium, titanium, and silicon, in a concentration to provide the first element layer described herein. Other cathodes (of the number of metal cathodes) may comprise further metal elements. In specific embodiments, aluminum is available with at least 67 at.% relative to a total of the metal elements, and silicon is available in the range of 0.5-2 at.% relative to the total of the metal elements, in (at least the subset of) the number Cat_{N} of metal cathodes (together).

The method further comprises depositing the coating at the substrate (by physical vapor depositing, especially in a depositing stage). During depositing (in the depositing stage) especially a gas atmosphere comprising nitrogen and/or a carbon containing gas, especially a nitrogen containing gas, is provided in the vacuum chamber. Furthermore (during depositing) an evaporation current to the cathodes, especially in the range of 40-150 A is applied (to vaporize part of the cathode), and especially while depositing a bias voltage, such as in the range of 30-300 V, may be applied to the substrate (to force positively charged metal ions to the substrate), to provide the coating to the substrate. In the depositing stage, the substrate may be rotated along a rotation axis. The coating is especially deposited (or "grown") layer-by-layer (or nano layer by nanolayer (see below)).

Hence, the method especially further comprises depositing the coating at the substrate (in the vacuum chamber) by physical vapor deposition, while providing one or more of (i) a nitrogen comprising gaseous fluid and (ii) a carbon comprising gaseous fluid, especially at least the nitrogen comprising fluid, in the vacuum chamber, and while rotating the substrate, to provide the coating, especially comprising the first layer element as defined herein. The term "gaseous fluid" especially relates to a gas.

Furthermore, in the depositing stage a vacuum pressure is created in the vacuum chamber such as lower than 10 Pa and especially at least 1.0 Pa, e.g., in the range of 1.5-8 Pa. In embodiments, the vacuum pressure is at least 1.0 Pa. In further embodiments, the vacuum pressure is equal to or lower than 8 Pa, especially equal to and lower than 5 Pa, such as equal to and lower than 2.5 Pa. In further embodiments, the vacuum pressure is selected to be at least 1.5 Pa, such as at least 2.5 Pa, especially at least 5 Pa. Especially, by using a vacuum of at least 2.5 Pa good results have been obtained. Further, especially at temperature in the vacuum chamber is controlled, such as at a temperature of 300-600 °C. In embodiments, the bias voltage is selected from the range of 50-100 V.

The evaporation current may be selected for each of the metal cathodes independently from the other cathodes. For instance, a first cathode may be provided with a current of less than 100 A., whereas a further (or second) cathode may be provided with a current of more than 100 A. Even more especially, the first cathode may be provided with a current > 100 A. and the second or further with a current <100 A. for providing a 1^{st} first layer element layer, and successively the current to the first cathode may be set to < 100 A. and, especially, the current to the second or further cathode may be set to >100 A. for providing a further first layer element layer having another composition. Hence, in embodiments, a variable (evaporation) current is provided to the metal cathodes. The evaporation current to respective cathodes may especially be changed during depositing the coating. In embodiments, the evaporation current of the cathode(s) comprising Si is changed during depositing for providing the different types of first layer element layers (with different Si content). In further embodiments (also) the current to the cathode(s) not comprising Si may (also) be changed for providing the different types of first layer element layers.

The method especially comprises selecting the metal cathodes and processing conditions to provide the first layer element. The term "processing conditions" is known and comprises for instance the evaporation current (to the cathodes), the bias voltage, the temperature (in the chamber), the pressure (in the chamber), a speed of rotation (of the substrate), a processing time, et cetera.

Hence, the depositing stage especially comprises depositing the coating at the substrate by physical vapor deposition, wherein one or more of (i) a nitrogen comprising gaseous fluid and (ii) a carbon comprising gaseous fluid (especially at least the carbon comprising gaseous fluid) is provided in the vacuum chamber during depositing, and especially wherein the substrate is rotated during depositing to provide the coating. The substrate may in embodiments be rotated around a central axis of the vacuum chamber. The depositing stage may comprise successively depositing one or more of the base layer element (described herein), the first layer element (described herein), and the top layer element (described herein). The depositing stage may further comprise depositing a further (functional) layer (element) before or after any of the above-mentioned layer elements.

The coating may be provided comprising the first layer element comprising one or more (stacked) first layer element layers, wherein each of the first layer element layers comprises a nitride layer, wherein the first layer element has an overall composition comprising the metal elements aluminum, chromium, titanium, and silicon, especially wherein aluminum is available with at least 72 at.% relative to a total of the metal elements, and especially wherein silicon is available in the range of 0.7-1.7 at.% relative to the total of the metal elements. During depositing, especially during depositing the first layer element, the nitrogen comprising gaseous fluid may be provided (wherein especially no carbon comprising gaseous fluid is provided in the vacuum chamber). During depositing any other layer element, especially during depositing the top layer element, the carbon containing gaseous fluid may also be provided to the vacuum chamber.

The method may further comprise cleaning of the substrate (in the vacuum chamber) prior to the depositing stage.

The metal cathodes, or "targets", may be selected for providing the coating of the invention. As such, at least a subset of the metal cathodes may comprise a single metal element selected from the group of aluminum, chromium, titanium, and silicon. Additionally or alternatively, the cathodes may comprise a combination of the different metal elements. Many different options to select a cathode for providing the coating described herein are possible. It will be clear to the person skilled in the art how to operate a PVD oven.

The metal cathodes are especially selected to provide the coating described herein. The cathodes not necessarily need to have the same composition as the final coating may have. Aluminum that is evaporated may, e.g., be deposited in a larger amount relative to other evaporated metal elements (titanium and chromium).Especially, increasing the bias voltage may result in a further enrichment of Al compared to Ti and Cr. Therefore, an overall composition of the (subset) of cathodes used for providing the first layer element may be selected to having a lower aluminum content than the final deposited first layer element may have. For depositing 74 at.% Al, e.g., a cathode comprising less than 74 at.%, such as 72 at.% or even 70 at.% may be applied in embodiments. In embodiments, the combinations of cathodes applied for the first layer comprises less than 70 at% Al (such a 65-70 at%), resulting in about 74 at.%.

The metal cathodes may further comprise sets of (the same) metal cathodes. For instance, one set of a first type of cathodes may be arranged at a first side of the vacuum chamber, and a second set of second types of cathodes may be arranged at another side of the vacuum chamber. If such set comprises the same type of cathodes, this may also be referred to as one (or a single) cathode. Hence, herein the term cathode may also relate to a plurality of (the same) cathodes.

Hence, in an embodiment each ((at least of the subset) of the number Cat_{N}) of the metal cathodes comprises (i) one or more of the metal elements Al, Cr, Ti, and Si or (ii) a combination of the metals Al, Cr, Ti, and Si. Further metal cathodes may comprise further metal elements. For instance, the subset of cathodes may comprise an aluminum, a chromium, a titanium, and a silicon cathode; or the subset may comprise an AlCr cathode, an AlSi cathode and an AlTi cathode; or the subset may comprise one or more AlTi cathodes, and an AlCrSi cathode, etc..

In a specific embodiment, at least one of the metal cathodes comprises the metal elements aluminum, titanium, and silicon, and at least another one of the metal cathodes comprises the metal elements aluminum and chromium. Hence, in embodiments, the cathodes comprise a first cathode comprising AlTiSi and a second cathode comprising AlCr. In further embodiments, the cathodes comprise (at least) two (second) cathodes comprising AlCr per one (first) cathode comprising AlTiSi. With such configurations durable coatings have been provided, especially wherein the first layer element comprises different first layer element layers. In yet further embodiments, at least one of the cathodes (a further or third or fourth cathode) comprises chromium (only). Further cathodes may comprise further metal elements that may be deposited in any one of the further layers or further layer elements. In further embodiments, the cathodes comprise a first cathode comprising AlCrSi and a second cathode comprising AlTi. In further embodiments, the cathodes comprise at least two cathodes comprising AlTi per one cathode comprising AlCrSi.

The first and the second cathodes are in embodiment arranged at opposite sides of the vacuum chamber. In further embodiments the first cathode is arranged between the (two) second cathodes. Hence, a line perpendicular to the central axis of the vacuum chamber may during a rotation around the central axis contact successively a first one of the second cathodes, the first cathode, and the other one of the second cathodes. The two second cathodes may be arranged at opposite sides of the central axis, i.e. at an angle of 180° with respect to the central axis, and e.g. the first cathode may be arranged at an angle of 90°. Surprisingly it was found that, in embodiments, minimizing the angle (with respect to the central axis) between the first cathode and one of the second cathodes may result in more durable coatings. In embodiments the first and second cathode may be arranged adjacent to each other, especially in the same plane, such as at the same wall of the oven.

Hence, in further embodiments a first cathode is arranged adjacent to a second cathode, e.g. wherein an inter-cathode distance between the first cathode and the second cathode is less than twice a dimension (especially width or diameter) of (one of) the (first and second) cathodes. The inter-cathode distance may especially be equal to or less than the dimension of one of the cathodes, such as in the range of 0.1-1, especially 0.1-0.7 times the dimension of one of the cathodes. Hence for circular cathodes with a dimeter of 100 mm this inter-cathode distance may be less than 100 mm, such as about 50 mm, or 10-30 mm. The inter-cathode distance is especially non-zero. The term "adjacent" in phrases like "the first and second cathode may be arranged adjacent to each other" especially relates to a configuration wherein the cathodes are arranged (next to each other) in a plane. The plane is especially parallel to a wall of the oven (wherein the cathodes are configured). The cathodes are especially configured at the same wall.

In further embodiments, at least one of the metal cathodes comprises silicon, and the at least one metal cathode comprising silicon is arranged adjacent to another one of the metal cathodes. In specific embodiments, the vacuum chamber comprises two AlCr cathodes, one AlTiSi cathode and a Cr cathode. Especially the two AlCr cathodes in combination with the AlTiSi cathode may be applied for providing the first layer element (layers). The Cr-cathode may further be applied for providing a base element and/or a top element.

In embodiments, the depositing stage is configured to provide the first layer element comprising a plurality of first layer element layers, wherein each of the first layer element layers comprises the metal elements Al, Cr, Ti, and Si, and wherein the first layer element layers comprise at least two different types of layers, wherein the different types of the (different) layers at least differ in a silicon content, wherein a first type of the (different types of) layers has a highest silicon content C_{Si,H}, and wherein a second type of the (different types of) layers has a lowest silicon content C_{Si,L}, wherein a ratio of the lowest silicon content C_{Si,L} to the highest silicon content C_{Si,H} is selected from the range 0.25≤C_{Si,L}/C_{Si,H}≤0.9, such as from the range of 0.4≤C_{Si,L}/C_{Si,H}≤0.6. In such embodiment, especially the current to the cathode(s) comprising silicon may be configured (controlled) to provide a change in silicon content in the different types of layers. Also the current to the cathodes not comprising silicon may be controlled to provide the change in silicon content in the different types of layer. Especially, a ratio of the current to a silicon containing cathode to the current to a cathode without silicon may be controlled to the change in silicon content in the different types of layer

Hence, the depositing (stage) may comprise depositing the at least two types (of different types) of first layer element layers, wherein at least one of the first type of the (different types of) layers is deposited before at least one of the second type (of the different) layers and/or wherein at least one of the first type (of the different types) of layers is deposited after at least one of the second type (of the different types) of layers.

In further embodiments, the depositing stage further comprises depositing the base layer element and/or the top layer element and/or any further (functional) layer. The depositing stage especially comprises depositing the coating described herein. Hence, the depositing stage especially comprises depositing the first layer element described herein.

The invention further provides a system ("system") for producing the article of the invention, especially the (coating tool) of the invention. The system comprises the physical vapor deposition oven (or physical vapor deposition system) comprising the vacuum chamber. The oven thus comprises at least the metal cathodes configured for providing the coating. The system is further configured to allow the processing conditions required to provide the coating at the substrate. The system may further comprise a control system for controlling the processing conditions. The control system may be a programmable system. Additionally or alternatively, the control system may be operated manually. The control system may be loaded with a software, especially a computer program, causing the control system to provide the coating at a substrate provided in the vacuum chamber, especially to bring about the method described herein, when it runs on the control system.

Hence, the invention further provides software, especially a computer program, that is configured to execute the method described herein (especially in the system described herein) when the computer program is running on a computer program functionally coupled to the physical vapor deposition oven, especially when the computer program is running on the control system (of the system of the invention).

The composition of the coating may e.g. be determined using SEM EDX (or EDS) or X-ray diffraction. Furthermore, the structure of different layers in detail may be analyzed using techniques in which the coating is removed layer by layer.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Fig. 1 schematically depict an embodiment of a tool according to the invention;
Figs 2 and 3 schematically depicts some aspects of the coating;
Figs 4-5 schematically depict some further aspects of the invention.

The schematic drawings are not necessarily to scale.

### DETAILED DESCRIPTION OF THE EMBODIMENTS

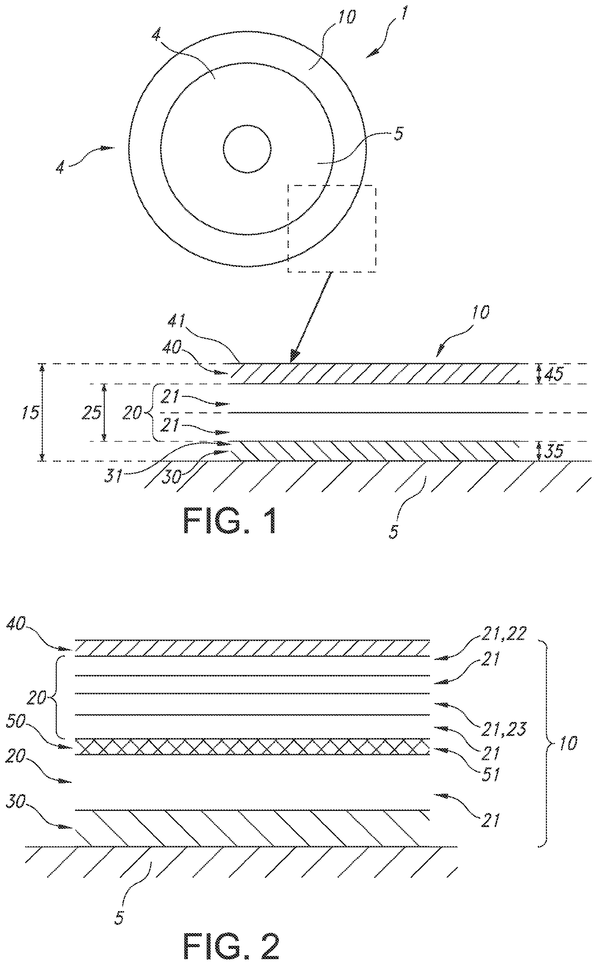

In Fig. 1, a saw blade is depicted as an embodiment of an article/cutting tool 1 of the invention. The tool 1 comprises a coating 10 on a substrate 5, especially a tribological coating. The coating 10 may only partly cover the substrate 5. In other embodiments, the coating may cover the entire of the exterior side(s) 4 of the substrate 5. The coating 10 comprises a first layer element 20, having an overall composition comprising the metal elements aluminum, chromium, titanium, and silicon. The first layer element 20 of Fig. 1 comprises two stacked first layer element layers 21. Any first layer element layer 21 may comprise a nitride layer which is also indicated herein as (AlCrTiSi)N.

In embodiments of the first layer element 20, Al is especially available with at least 72 at.% and especially at maximum 77 at.%, Si is especially available in the range of 0.7-1.7 at.%, Ti is especially available with at least 5 at.%, and Cr is especially available with a maximum of 20 at.%; all relative to the total of the metal elements (in the first layer element 20). Herein, this may also be indicated by the first layer element 20 comprises AlₐCr_{b}Ti_{c}Si_{d}, especially wherein 0.72≤a≤0.77, especially wherein b<0.2; especially wherein c ≥ 0.05, and especially wherein 0.007≤d≤0.017. In further embodiments of the first layer element 20 0.72≤a≤0.77; 0.13≤b≤0.2; 0.05≤c≤0.11; and 0.007≤d≤0.017.

The coating 10 comprises a coating thickness 15 that is defined in Fig. 1 by a thickness 25 of the first layer element 20, a base layer element thickness 35 and a top layer element thickness 45. It is noted that these respective layer elements 10, 20, 30, and 40 not necessarily are present in all embodiments. The thickness 25 of the first layer element 20 (or "first layer element thickness" 25 may especially be in the range of 1-12 µm, such as 2-7 µm. The first layer element thickness 25 may e.g. be in the range of 1-4 µm, such as 1-2.5 µm for a mono layer, i.e. wherein the first layer element 20 comprises a single first layer element layer 21 or a plurality of first layer element layers 21 with the same or especially different composition. The thickness 25 of the first layer element 20 may in further embodiments be in the range of e.g. 3-7 µm

Furthermore, the coating thickness 15 may in embodiments be 3-8 µm. In further embodiments, the coating thickness may be in the range of 1-3 µm. Both the top layer element thickness 45 and the base layer element thickness 35 may especially be in the range of 0.05-1.5 µm, such as 0.2-1.2 µm. The top layer element thickness 45 may in embodiments be smaller (or larger) than the based layer element thickness 35. In embodiments the top layer element thickness 45 is in the range of 0.05-0.3 µm. In further embodiments, the base layer element thickness 35 is in the range of 0.3-1 µm.

The base layer element 30 may comprise one or more base layer element layers 31, e.g., comprising nitride layers, such as comprising CrN or AlCrN. The top layer element 40 may (also) comprise one or more top layer element layers 41, especially any one of these top layer element layers 41 comprising a nitride layer or a carbonitride layer, such as an AlN, CrN, ALCrN, AlCN, CrCN, or AlCrCN layer.

The coating 10 may further comprise an intermediate layer element 50 comprising an intermediate layer element layer 51, as is depicted in Fig. 2. The intermediate layer element 50 is especially arranged between two of first layer elements 20. The intermediate layer element layer 51 especially comprises a nitride layer comprising one or more of the metal elements aluminum, titanium and chromium, especially AlTiN, CrN or AlCrN. Two first layer elements 20 may also be stacked without having an intermediate layer element 50 in between. It will further be appreciated that the coating 10 may further comprise further layer (elements) at any location in the coating.

Herein the terms "top" "upper", "higher", "above", "over", etc. in relation to the coating 10 may especially refer to a location most (or further) remote from the substrate 5 (with respect to another location). Likewise the terms "base", "lower" "under" and the like may be located closer or closest to the substrate 5.

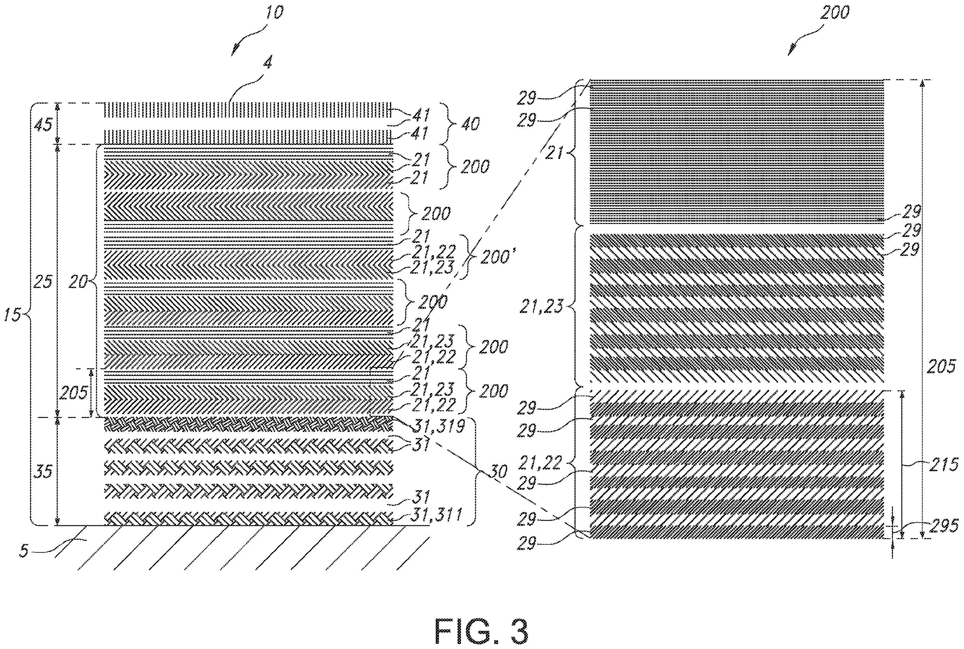

In Fig. 3, an embodiment of a coating 10 is depicted in further detail. The embodiment comprises the base layer element 30 comprising a plurality of base layer element layers 31. The arrangement of the plurality of base layer element layers 31 is especially configured to improve the adherence of the first layer element 20 to the substrate 5. For that, the aluminum content of the upper base layer element layer 319 (contacting the first layer element 20) may be higher than the aluminum content in the lower base layer element layer 311 (contacting the substrate 5). Moreover the aluminum content of successive base layer element layers 31 stacked on top of each other in a direction from the substrate 5 to the exterior side 4 of the cutting tool 1 may (gradually) increase

Fig. 3 (as well as Fig. 2) further depicts the first layer element 20 comprising a plurality of first layer element layers 21. The first layer element layers 21 comprise different types of layers, of which two different types of layers 22, 23 are indicated. These different types of the layer 22, 23 differ in a silicon content and thus also in the content of at least one of the other metal elements Al, Cr, and Ti, which are especially all comprised in each of the first layer element layers 21. Hence a first type 22 of the layers 22, 23 has a highest silicon content C_{Si,H}, and a second type 23 of the layers 22, 23 has a lowest silicon content C_{Si,L},

The ratio of the lowest silicon content C_{Si,L} to the highest silicon content C_{Si,H} may e.g., be about 0.5. For instance, C_{Si,H} may be about 1.5 at% and C_{Si,L} may be about 0.7 at%.

Fig. 3, further depicts the cutting tool 1 wherein the plurality of first layer element layers 21 comprise a number subs_{N} of subsets 200 of the first layer element layers 21. A number of different first layer element layers 21 thus may define a subset 200 of first layer element layers 21 The depicted embodiment comprises six stacked subsets 200 (here subs_{N} equals six), all comprising the first type 22 of the layers 22, 23 and the second type 23 of the layers 22, 23 plus a third (other) first layer element layer 21. Hence, at least two of the first layer element layers 21 in a subset 200 may comprise different silicon contents. In the depicted embodiment, a first first layer element layer 21, 23 (of the subset 200) may comprise a lowest silicon content, e.g. 0.7 at%; a second first layer element 21,22 (of the subset (200) may comprise a higher silicon content, e.g. 1.5 at%, and a third first layer element layer 21 may comprises an intermediate silicon content, e.g. 1 at%.

Also the subset thickness 205 is indicated. The subset thickness 205 of each of the subsets 200 may be equal to or smaller than 1.5 µm, especially equal to or smaller than 1 µm or equal to or smaller than 0.5 µm. Further, the thickness 215 of the first layer element layer 21 may in the given embodiment be in the range of equal to or smaller than 0.5 µm, especially equal to or smaller than 0.4 µm, such as equal to or smaller than 0.33 µm, such as equal to or smaller than 0.2 µm. In further embodiments, the thickness 205 of the subset 200 is in the range of 0.6-1.2 µm, especially in the range of 0.7-1 µm.

In embodiments, the configuration of the first layer element layers 21 in each of the subsets 200 may be identical. As such, the first layer element 20 may comprise a configuration with repeating first layer element layer 21 composition. If the embodiment in Fig. 3 would only comprise the lower three subsets 200, such a repeating configuration would have been provided. Yet, the configuration in one or more of the subsets 200 may also differ from the configuration of the other subsets 200 as is depicted with the subset 200' on top of the lower three subsets 200. Other configurations are part of the invention as well. For instance, in yet further embodiments, the first layer element 20 comprises a number of subsets 200 configured between two (further) first layer element layers 21 (especially being different from the first layer element layers 21 in the subset 200).

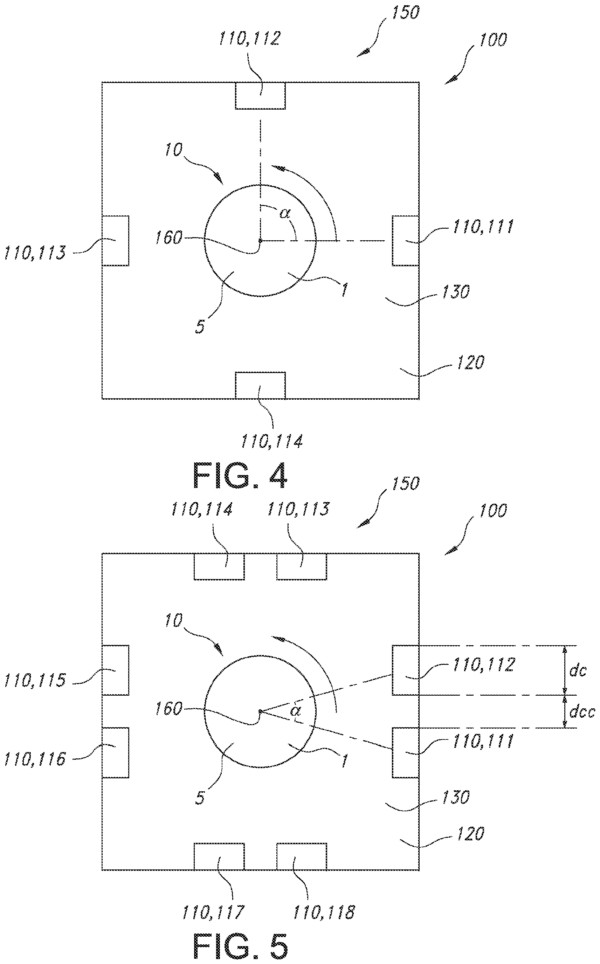

The coating 10 of the invention may be produced by physical vapor deposition (PVD). During PVD the substrate 5 is rotated and especially during every rotation a very thin film or nanolayer 29 may be deposited. As such, every layer may comprise a plurality of stacked nano layers 29 as is also depicted in Fig. 3. For instance, the lowest first layer element layer 21; in the present embodiment a first type 22 of layer, comprises twelve of such nanolayers 29. The total of these nanolayers 29 may especially define the first layer element layer 21. The term "nanolayer" is known to the skilled person and especially refers to a layer in which the atoms provide a closed layer structure. A nanolayer may have a thickness 295 of only a few (metal) atoms, e.g. in the range of only a few nanometers up to e.g. several tens of nanometers. The nanolayer 29 may in embodiments have a thickness 295 in the range of 10-100 nm, especially 20-80 nm, such as 20-70 nm, especially 25-50 nm. Based on the rotation, the configuration of the cathodes 110 (see e.g. Figs 4-5) and especially the (variable) current applied, the composition of each nanolayer 29 may be heterogeneous, whereas the overall composition of each nanolayer 29 in the first layer element layer 21 is substantially the same (see below). A thickness 215 of the first layer element layer 21 may especially be hundreds of nanometers, e.g. in the range of 0.1-1 µm, especially in the range of 0.1-0.5 µm. In embodiments, the first layer element layer thickness 215 may be in the range of 100-500 nm, such as 250-400 nm.

Fig. 4, very schematically depicts a physical vapor deposition oven 100 with a vacuum chamber 150 comprising four metal cathodes 110. It is noted that each cathode 110 may be a single cathode 110. Yet, each cathode 110 may also represent a set or a plurality of the same cathodes 110. In the depicted embodiment, the number of cathodes Cat_{N} is four. In the figure also a central axis 160 of the vacuum chamber 150 is depicted. Further, also the angle α between the cathodes 11 and 112 is depicted. Herein this angle α may also be described as the angle α between the cathodes (relative to the central axis 160).

For providing the first layer element 20, at least a subset of the Cat_{N} cathodes 110, such as cathode 111, cathode 112, and cathode 113 together at least comprise Al, Cr, Ti, and Si. For providing other metal elements, at least one of the cathodes 110, e.g., cathode 114, may comprise the other elements

In Fig. 5 a further embodiment of a PVD oven 100 is depicted. In the embodiment, at each wall of the oven two cathodes 110 may be configured. This way two different cathodes 110, e.g. cathode 111 and cathode 112 may be arranged much closer to each other at an angle α being much smaller than 90°, e.g. at an angle α in the range of only a few degrees to less than 40 degrees, especially less than 25 degrees. Moreover, this way two cathodes 110, e.g. cathode 111 and cathode 112 may be arranged adjacent to each other, especially in one plane. The cathodes 111 and 112 are especially arranged at an inter-cathode distance dcc, which in this embodiment is smaller than the cathode dimension (or diameter) dc of cathode 112. Such configuration may in embodiments improve a distribution of silicon in the coating 10 being deposited if one of the cathodes indicated with reference 111 or 112 comprises the silicon.

It is noted that not all cathodes depicted in Figs 4-5 actually are present. The indicated cathodes 110 depict possible positions for a cathode 110. In further embodiments heating elements may be configured at one or more of the walls of the oven 100, and e.g. positions 113, 114, 117, and 118 are not present in the oven (because the respective walls comprise heating elements).

In the method, the substrate 5 is provided in the vacuum chamber 150 (wherein a vacuum is created) at temperatures in the range of 300-600 C°. During depositing the substrate 5 is rotated as is indicated by the arrow. In the given embodiments around the central axis 160 of the chamber 150. Furthermore, for obtaining a nitride layer a nitrogen comprising gaseous fluid 120, such as nitrogen gas, is provided in the vacuum chamber 150. Optionally, especially during depositing the top layer element, also a carbon comprising gaseous fluid 130, e.g. methane, ethane, ethylene, or acetylene, is provided in the vacuum chamber 150 for providing a carbonitride layer. Further, metal and metalloid elements from the metal cathode 110 are evaporated by providing an electrical current to the cathode 110. The metal elements may react with the gaseous fluids 120, 130 and are attracted to the substrate by providing a (negative) bias voltage to the substrate 5 (over the substrate 5 and the vacuum chamber 150) and deposit on the substrate 5, thereby growing the coating 10, nanolayer 29 by nanolayer 29; layer by layer.

The composition of the coating 10 may thus among others be controlled by the composition of the cathodes 110. Yet, also the current to the cathodes 110, the positioning of the cathodes 110, the bias voltage, the temperature and the pressure in the chamber 150 may be configured for controlling the composition of the coating 10. By using four (sets) of cathodes 110, e.g. each single cathode 111, 112, 113, 114 could comprise just one or two (or more) of the respective metals Al, Cr, Ti, Si. Alternatively all the cathodes 110 may comprise a combination of the metals aluminum, chromium, titanium, and silicon. The different cathodes 110 may further have the metal elements in different ratios. Yet, in embodiments, one of the cathodes 110, e.g. cathode 114, may be configured for providing the base layer element 30 and/or the top layer element 40, and/or the intermediate layer element 50, optionally in combination with one or more of the other cathodes 111, 112, 113. In further embodiments, three cathodes 111, 112, 113, may be configured for providing the first element layer element 20. Hence, in embodiments three cathodes 110 together comprise the elements Al, Ti, Cr, and Si, especially in an amount that agrees with the composition of the coating 10, especially the first layer element 20 (of the invention) to be produced (taking into account that some metal elements may be deposited more preferred than other metal elements).

By using eight (sets) of cathodes 110, 111-118 (see Fig. 5) a degree of freedom is even further increased, In further embodiments, (at least) one of the cathodes 111, 112, 113, or e.g. of cathodes 111-118, may comprise an AlTiSi (or an AlCrSi) cathode (i.e. a cathode 110 substantially only containing the elements Al, Ti, (or Cr) and Si in a predetermined ratio) (herein also especially indicated as the first cathode) and one or two other ones of the cathodes 111, 112, 113 may comprise an AlCr (or ALTi) cathode (comprising substantially only Al and Cr (or Ti)) (herein also especially indicated as the second cathode(s)). In embodiments, the Si-containing cathode (such as AlCrSi) may be arranged between two AlTi cathodes. For instance cathodes 111 and 113 may be the second cathodes, such as AlTi cathodes, and cathode 112, arranged between the other two others 111, 113, may then be the first cathode, such as the AlCrSi cathode. The further cathode 114 arranged between the two other cathodes 111, 113 may e.g. comprise a Cr cathode. Yet other configurations are also feasible, wherein, e.g., cathodes 114 and 113 or 111 comprise second cathodes (and cathode 112 the first cathode). Further, with reference to Fig. 5, e.g. the first cathode may be arranged at position 112, and the second cathodes may be arranged at position 111 and e.g. position 114 or position 116. The first cathode may in further embodiments be arranged adjacent to one of the second cathodes and opposite to a further second cathode. For instance, a silicon containing cathode may be arranged at position 111 and the second electrodes (without silicon) may be arranged at positions 112 and 116. In embodiments, using AlCr (or AlTi) second cathodes 110 and an AlTiSi (or AlCrSi) first cathode 110 durable coatings 10 were produced when arranging a second cathode 110 adjacent to a first cathode 110 and opposite to a first cathode 110.

Having cathodes 110 comprising Al, Cr and/or Ti, but without containing Si, while having other cathodes 110 comprising Si allows for depositing the first layer element layers 21 comprising at least two different types of layers 22, 23, wherein the first type 22 has the highest silicon content C_{Si,H}, and the second type 23 has the lowest silicon content C_{Si,L}. This may e.g. be achieved by controlling the current (value(s) or duration) to change the amount of metal elements evaporated. By changing the current to the cathodes 110 also the amount of evaporated other metal and metalloid elements in the cathode 110 may change. This may in embodiments especially affect the titanium and/or chromium content in the coating 10. In embodiments, especially in each of the first layer element layers 21 a combination of titanium and chromium is available in the range of 21-27 at.%, such as in the range of 22-27 at.% relative to a total of the metal and the metalloid elements (in the respective) first layer element layer 21).

As discussed above, based on the composition and location of the cathodes 110 and because of the rotation of the substrate 5 during depositing a nanolayer 29 may be deposited every rotation. Such nanolayer 29 may therefore in embodiments comprise a heterogeneous composition. Hence, the first element layer 21 may comprise a repeating structure comprising a number of these nanolayers 29 stacked on top of each other, see Fig. 3. It is hypothesized that changing structures in the coating 10 facilitates the tool life. Moreover, it is hypothesized that also such substructure in the first layer element layer may positively affect the durability of the coated article 1.

The term "plurality" refers to two or more. Furthermore, the terms "a plurality of" and "a number of" may be used interchangeably. The terms "substantially" or "essentially" may also include embodiments with "entirely", "completely", "all", etc. Hence, in embodiments the adjective substantially or essentially may also be removed. Where applicable, the term "substantially" or the term "essentially" may also relate to 90% or higher, such as 95% or higher, especially 99% or higher, even more especially 99.5% or higher, including 100%. Moreover, the terms "about" and "approximately" may also relate to 90% or higher, such as 95% or higher, especially 99% or higher, even more especially 99.5% or higher, including 100%. For numerical values it is to be understood that the terms "substantially", "essentially", "about", and "approximately" may also relate to the range of 90% - 110%, such as 95%-105%, especially 99%-101% of the values(s) it refers to.

The term "and/or" especially relates to one or more of the items mentioned before and after "and/or". For instance, a phrase "item 1 and/or item 2" and similar phrases may relate to one or more of item 1 and item 2. The term "comprising" may in another embodiment also refer to "containing at least the defined species and optionally one or more other species".

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

The devices, apparatus, or systems may herein amongst others be described during operation. As will be clear to the person skilled in the art, the invention is not limited to methods of operation, or devices, apparatus, or systems in operation.

It should be noted that the above-mentioned embodiments illustrate rather than limit the invention, and that those skilled in the art will be able to design many alternative embodiments without departing from the scope of the appended claims.

In the claims, any reference signs placed between parentheses shall not be construed as limiting the claim.

Use of the verb "to comprise" and its conjugations does not exclude the presence of elements or steps other than those stated in a claim. Unless the context clearly requires otherwise, throughout the description and the claims, the words "comprise", "comprising", "include", "including", "contain", "containing" and the like are to be construed in an inclusive sense as opposed to an exclusive or exhaustive sense; that is to say, in the sense of "including, but not limited to".

The article "a" or "an" preceding an element does not exclude the presence of a plurality of such elements.

The invention may be implemented by means of hardware comprising several distinct elements, and by means of a suitably programmed computer. In a device claim, or an apparatus claim, or a system claim, enumerating several means, several of these means may be embodied by one and the same item of hardware. The mere fact that certain measures are recited in mutually different dependent claims does not indicate that a combination of these measures cannot be used to advantage.

The invention also provides a control system that may control the device, apparatus, or system, or that may execute the herein described method or process. Yet further, the invention also provides a computer program product, when running on a computer which is functionally coupled to or comprised by the device, apparatus, or system, controls one or more controllable elements of such device, apparatus, or system.

The invention further applies to a device, apparatus, or system comprising one or more of the characterizing features described in the description and/or shown in the attached drawings. The invention further pertains to a method or process comprising one or more of the characterizing features described in the description and/or shown in the attached drawings. Moreover, if a method or an embodiment of the method is described being executed in a device, apparatus, or system, it will be understood that the device, apparatus, or system is suitable for or configured for (executing) the method or the embodiment of the method respectively.

The various aspects discussed in this patent can be combined in order to provide additional advantages. Further, the person skilled in the art will understand that embodiments can be combined, and that also more than two embodiments can be combined. Furthermore, some of the features can form the basis for one or more divisional applications.

### EXPERIMENTAL

### Tool life for cutting tubes

Saw blades (both HSS saw blades as well as TCT saw blades) with different coatings have been tested. The coating composition was measured by SEM-EDX During the test, the saw blade was inspected at regular intervals of 1.2 m² with an optical microscope with 500x magnification.. The tests were stopped when a certain degree of damaged was observed.

TCT coated blades (350 mm diameter, kerf 2.7 mm, 120 teeth) were tested on a Rattunde ACS90 cutting machine, for cutting E355+N tubes with 50 mm diameter and 3 mm wall thickness. The cutting speed was 280 m/min, while the feed varied between 0.05 mm/tooth at the entrance and the exit of the tube, to 0.14 mm/tooth at the middle of the tube. So called micro spraying with emulsion was used for cooling and lubrication of the saw blade.

In the following table some relevant results on TCT coated blades are given:

| Experiment / sample no | Coating composition (excluding N and C) | | | | Functional layer | | Wear/damage @ m² |
|---|---|---|---|---|---|---|---|
| | Al at.% | Cr at.% | Ti at.% | Si at.% | structure | Thick ness | |
| Prior art 1 | 75 | 1 | 24 | 0 | Multi | 7 µm | Heavy damage at 1.2 m² |
| Prior art 2 | 75 | < 0.2 | 25 | 0 | Mono | 4 µm | Heavy damage at 1.2 m² |
| Prior art 3 | 80 | 19 | 0 | 1 | Mono | 6 µm | Heavy damage at 1.2 m² |
| Prior art 4 | 71 | 29 | 0 | 0 | Mono | 6 µm | Damage at 5 m² |
| Example 0 (V38) | 78 | 22 | 0 | 0 | Mono | 6 µm | Damage at 1.2 m² |
| Example 1 (V42) | 73 | 18 | 8 | 1 | 2 layer | 5 µm | Damage at 2.4 m² |
| Example 1b (V43) | 74 | 17 | 8 | 1 | Mono [like V42] | 3 µm | Damage at 1.2 m² |
| Example1c (V44) | 73.5 | 15 | 9 | 2.5 | Mono | 2.5 µm | Damage at 1.2 m² |
| Example 1d (V45) | 74 | 19.5 | 5 | 1.5 | Mono | 3.5 µm | Damage at 2.4 m² |
| Example 1e (V46) | 74 | 19.5 | 5 | 1.5 | Mono [like V45] | 2.5 µm | Damage at 1.2 m² |
| Example 2 (V47) | 74 | 16.5 | 8.5 | 1 [1;1.5] | Multi [CB] | 4.5 µm | Damage at 3.7 m² |
| Example 3 (V48) | 74 | 17 | 8 | 1 | Mono [like V43] | 4.5 µm | Heavy damage at 5 m² |
| Example 4 (V49) | 73.5 | 13.5 | 11.5 | 1.5 | 2 layer ** | 5 µm | Damage at 1.2 m² |
| Example 5 (V50) | 74 | 17 | 8 | 1 [0.7;1.5;1] | Multi [CBA] | 5 µm | First wear signs at 5 m²; Can still be used after 7.4 m² |
| Example 6 (V52) | 74 | 18 | 7 | 0.9 [1;0.7] | Multi [CA] | 5 µm | Damage at 5 m²; Cannot be used after 6.2 m² |

In the table, the structure "mono" indicates that the saw blade has a coating comprising a single functional layer. The term "2 layers" indicates that the saw blade has two different functional layers (with Si). The term "multi" indicates that the first layer element comprises two or three different first layer element layers with different composition, the different compositions for the layers in the multilayers are indicated (with A, B, and C) between brackets under the term "multi" and the silicon amounts in the respective layers are indicated between brackets in the column "Coating composition; Si" (i.e. layer A comprising 1 at.% Si, layer B comprising 1.5 at% Si and layer C comprising 0.7 at% Si). Further, comparable coating compositions are also indicated in the column "structure". The coatings further have a base layer, a top layer and optionally intermediate layers. In the experiments indicated as Example 1 to 1e, 2 to 3 and 5 to 6, four cathodes were used, wherein a first cathode consisted of aluminum and chromium (AlCr), a second one also consisted of aluminum and chromium (AlCr), a third cathode consisted of aluminum, titanium, and silicon (AlTiSi) and a fourth consisted of Cr (especially applied for the base layer element and/or the top layer element). In these experiments the second cathode and the third cathode were arranged next to each other and opposite to the first cathode (as well as the fourth cathode), i.e. referring to Fig. 5, for instance at positions 112, 111 and 116 (and 115) for respectively the second, third, and first (and fourth) cathode. As such, every composite layer is built layer-by-layer by a combination of cathodes 2 and 3 providing AlCrTiSiN and stacked by AlCrN provided by the oppositely arranged first cathode. For example 4 (experiment V49) also cathode 2 (AlCr) and cathode 3 (AlTiSi) were used. However, cathodes 2 and 3 were configured 180° from each other (opposite to each other) instead of adjacent to each other (and the Cr cathode was arranged next to cathode 2). Again referring to Fig. 5, for instance cathode 2 was arranged at position 112, and cathode 3 was arranged ta position 116 (and the Cr cathode at position 111.

Based on these experiments the next conclusions are drawn: Prior art coatings 1-3 all show heavy damage at 1.2 m², which is worse than all coatings of the invention

A saw blade with a coating resembling a coating as described herein, having two different first layer element layers with different compositions, but without silicon in the first layer element (Example 0) has a shorter tool life than the saw blades of the invention with the coatings described herein comprising 1 at.% silicon (Examples 1-3 and 5) and about the same tool life as Example 4, also comprising two first layer element layers with different composition, wherein the silicon content is about 1.5 at.%.

Further, it appears that if the silicon containing cathode is placed too far apart from the cathode without silicon as is done for Example 4, a less durable coating is obtained. It is assumed that in this experiment the structure that is needed, consisting of Al, Cr, Ti and Si forming one structure is not formed, but instead of this segregated structures of AlCrN and AlTiSiN are formed.

The position of the first AlCr cathode opposite to the combination of the second AlCr cathode and the AlTiSi cathode configured adjacent to each other (as used in the other experiments) leads to a confinement of AlCrTiSiN structure which consists of a Si₃N₄ center surrounded by AlCrTiN. When this structure grows too large, which would happen without the intermediate AlCr nano layers, an unstable structure appears to be formed which weakens the overall coating structure.

Further, all saw blades according to the invention seem to have a longer tool life than a prior art saw blade also comprising silicon, however not comprising titanium (prior art 3).

Especially multi layers seem to have a positive effect on the tool life during cutting of tubes (tube material). Example 5 seems to have the longest tool life. In example 5 the coating comprises about 15 first layer element layers comprising three different layer types.

It is to be expected that each individual layer varies in hardness, hot hardness, elastic modulus, tendency to chip welding and friction coefficient, as a direct consequence of the differences in Ti, Cr and Si concentration. It hypothesized that every individual layer can withstand the most dominant wear mechanism for each individual part of the tool: the most resistant layer survives the mechanism at play, the other layers quickly wear off. No single composition layer is capable to withstand the multiple modes of wear. Therefore, probably three different layers may provide a more durable coating than layers comprising two different compositions. The coating V50 has a structure where repeatedly three different layers are stacked, which seems to result in the longest tool life. For coatings having one or two of these three different layers, the coating seemed to fail earlier, and tool life is limited. This may especially be important when cutting a highly abrasive material intermittently, such as tubes, where several wear mechanisms are at play simultaneously at different parts of the tool.

### Tool life for cutting Solids

For solid materials other mechanism may play a dominant rule. Using further experiments, it has been shown that for solid cutting, a single layer structure, as used in example 1b, 1c, and 3 showed good results and sometimes better than especially thicker multilayered coatings.

## Claims

1. A cutting tool (1) comprising a coating (10) on a substrate (5), wherein the coating (10) comprises a first layer element (20), wherein the first layer element (20) has an overall composition comprising the metal or metalloid elements aluminum, chromium, titanium, and silicon, wherein the metal or metalloid elements aluminum, chromium, titanium, and silicon define at least 99 at% of a total of the metal and metalloid elements in the first layer element (20) wherein the first layer element (20) comprises a number N_{lay} of first layer element layers (21), wherein N_{lay} is at least 2, wherein each of the first layer element layers (21) is a nitride layer of the metal or metalloid elements aluminum, chromium, titanium and silicon, wherein the N_{lay} first layer element layers (21) comprise at least two different types of layers (22, 23), wherein the different types of layer (22, 23) at least differ in a silicon content, wherein a first type (22) of the layers (22, 23) has a highest silicon content C_{Si,H} expressed in at.%, relative to a total of the metal and metalloid elements, and wherein a second type (23) of the layers (22, 23) has a lowest silicon content C_{Si,L} expressed in at%, relative to a total of the metal and metalloid elements, wherein a ratio of the lowest silicon content C_{Si,L} to the highest silicon content C_{Si,H} is selected from the range of 0.25≤C_{Si,L}/C_{Si,H}≤0.9; wherein a thickness (25) of the first layer element (20) is selected from the range of 1-12 µm; wherein in the first layer element (20), relative to a total of the metal and the metalloid elements
- aluminum is available in the range of 72-77 at.%,
- titanium is available in the range of 5-11 at.%,
- chromium is available in the range of 13-20 at.%, and
- silicon is available in the range of 0.7-1.7 at.%.

2. The cutting tool (1) according to claim 1, wherein the ratio of the lowest silicon content C_{Si,L} to the highest silicon content C_{Si,H} is selected from the range of 0.4≤C_{Si,L}/C_{Si,H}≤0.6.

3. The cutting tool (1) according to any one of the preceding claims, wherein C_{Si,H} ≤ 1.7 and C_{Si,L} ≤1.

4. The cutting tool (1) according to any one of the preceding claims, wherein the first layer elements layers (21) have a first layer element layer thickness (215) in the range of 0.1-0.5 µm.

5. The cutting tool (1) according to any one of the preceding claims, wherein in each of the first layer element layers (21) a combination of titanium and chromium is available in the range of 21-27 at.% relative to a total of the metal and the metalloid elements.

6. The cutting tool (1) according to any one of the preceding claims, wherein the plurality of first layer element layers (21) comprise a number subs_{N} of stacked subsets (200) of the first layer elements layer (21), wherein subs_{N} is at least 2, and wherein each of the subsets (200) comprises the first type (22) of the layers (22, 23) and the second type (23) of the layers (22, 23), wherein a subset thickness (205) of each of the subsets (200) is equal to or smaller than 1 µm.

7. The cutting tool (1) according to claim 6, wherein at least one of the subsets (200) of the stacked subsets (200) comprises at least three different types of first layer element layers (21).

8. The cutting tool (1) according to any one of the preceding claims, wherein a thickness (25) of the first layer element (20) is selected from the range of 2-7 µm.

9. The cutting tool (1) according to any one of the preceding claims, wherein the coating (10) further comprises (i) a base layer element (30) arranged between the substrate (5) and the first layer element (20) and/or (ii) a top layer element (40) arranged over the first layer element (10), wherein a base layer element thickness (35) of the base layer element (30) is selected from the range of 0.2-1.2 µm, wherein the base layer element (30) comprises one or more base layer element layers (31), wherein any one of the base layer element layers (31) comprises a nitride layer comprise chromium nitride and/or aluminum-chromium-nitride; and wherein a top layer element thickness (45) of the top layer element (40) is selected from the range of 0.2-1.2 µm, wherein the top layer element (40) comprises one or more top layer element layers (41), wherein any one of the top layer element layers (41) comprises (i) a nitride layer comprising chromium and/or aluminum or (ii) a carbonitride layer comprising chromium and/or aluminum; and where a total coating thickness (15) of the coating (10) is selected from the range of 3-8 µm.

10. The cutting tool (1) according to claim 9, comprising the base layer element (30), wherein the base layer element (30) comprises a plurality of base layer element layers (31), wherein an aluminum content of an upper base layer element layer (319) configured closest to the first layer element (20) is higher than the aluminum content in a lower base layer element layer (311) configured closest to the substrate (5).

11. The cutting tool (1) according to any one of the preceding claims, wherein the cutting tool (1) is a circular saw blade, a tool bit, a router bit, or a drill.

12. The cutting tool (1) according to any one of the preceding claims wherein the substrate (5) comprises one or more of an uncoated drill bit, an uncoated saw blade, an uncoated tooth of a saw blade, an uncoated tip of a sawblade, and an uncoated insert of a saw blade.

13. A method for producing a cutting tool (1) comprising a coating (10) according to any one of the claims 1-12, by physical vapor deposition, the method comprising:
- providing a substrate (5) into a vacuum chamber (150) of a physical vapor deposition oven (100), wherein the chamber (150) comprises a number Cat_{N} of metal cathodes (110), wherein Cat_{N} is at least 3, wherein at least a subset of the number Cat_{N} of metal cathodes (110) together comprise the metal or metalloid elements aluminum, chromium, titanium, and silicon in a concentration to provide the first layer element, and
- depositing the coating (10) at the substrate (5) by physical vapor deposition, wherein (i) a nitrogen comprising gaseous fluid and optionally (ii) a carbon comprising gaseous fluid (130) is provided in the vacuum chamber (150), while rotating the substrate (5), wherein the coating (10) is deposited layer-by-layer, to provide the coating (10), wherein an evaporation current to a cathode (110) comprising silicon is changed during depositing and/or wherein a current to a cathode (110) not comprising silicon is changed during depositing, for providing the at least two different types of layers (22, 23) of the first layer element (20) with a different Si content.

14. The method according to any one of the claims 13, wherein (i) at least one of the metal cathodes (110) comprises the metal or metalloid elements aluminum, titanium, and silicon, and wherein at least another one of the metal cathodes (110) comprises the metal elements aluminum and chromium or wherein (ii) at least one of the metal cathodes (110) comprises the metal elements aluminum, chromium, and silicon, and wherein at least another one of the metal cathodes (110) comprises the metal elements aluminum and titanium, and wherein the during deposition, a variable evaporation current is provided to the metal cathodes (110).

15. The method according to any one of claims 13-14, wherein (i) a first cathode is an AlCrSi cathode and a second cathode is an AlTi cathode or (i) the first cathode is an AlTiSi cathode and the second cathode is an AlCr cathode, wherein the metal cathodes (110) comprise at least two second cathodes per first cathode, wherein the substrate (5) is rotated around a central axis (160) of the vacuum chamber (150), wherein the second cathodes are arranged at opposite sides of the central axis (160), and wherein the first cathode is arranged adjacent to one of the second cathodes in a plane parallel to a wall of the physical vapor deposition oven (100).

## Patentansprüche

1. Schneidwerkzeug (1), das eine Beschichtung (10) auf einem Substrat (5) umfasst, wobei die Beschichtung (10) ein erstes Schichtelement (20) umfasst, wobei das erste Schichtelement (20) eine Gesamtzusammensetzung aufweist, welche die Metall- oder metallähnlichen Elemente Aluminium, Chrom, Titan und Silicium umfasst, wobei die Metall- oder metallähnlichen Elemente Aluminium, Chrom, Titan und Silicium wenigstens 99 Atom-% einer Gesamtmenge der Metall- und metallähnlichen Elemente in dem ersten Schichtelement (20) definieren, wobei das erste Schichtelement (20) eine Anzahl N_{lay} von Schichten (21) des ersten Schichtelements umfasst, wobei N_{lay} wenigstens 2 beträgt, wobei jede der Schichten (21) des ersten Schichtelements eine Nitridschicht der Metall- oder metallähnlichen Elemente Aluminium, Chrom, Titan und Silicium ist, wobei die N_{lay} Schichten (21) des ersten Schichtelements wenigstens zwei unterschiedliche Arten von Schichten (22, 23) umfassen, wobei die unterschiedlichen Arten von Schichten (22, 23) sich wenigstens in einem Siliciumgehalt unterscheiden, wobei eine erste Art (22) der Schichten (22, 23) einen höchsten Siliciumgehalt C_{Si,H}, angegeben in Atom-%, bezogen auf eine Gesamtmenge der Metall- und metallähnlichen Elemente, aufweist und wobei eine zweite Art (23) der Schichten (22, 23) einen niedrigsten Siliciumgehalt C_{Si,L}, angegeben in Atom-%, bezogen auf eine Gesamtmenge der Metall- und metallähnlichen Elemente, aufweist, wobei ein Verhältnis des niedrigsten Siliciumgehalts C_{Si,L} zu dem höchsten Siliciumgehalt C_{Si,H} aus dem Bereich von 0, 25≤C_{Si,L}/C_{Si,H}≤0, 9 ausgewählt ist; wobei eine Dicke (25) des ersten Schichtelements (20) aus dem Bereich von 1-12 µm ausgewählt ist; wobei in dem ersten Schichtelement (20), bezogen auf eine Gesamtmenge der Metall- und der metallähnlichen Elemente
- Aluminium im Bereich von 72-77 Atom-% verfügbar ist,
- Titan im Bereich von 5-11 Atom-% verfügbar ist,
- Chrom im Bereich von 13-20 Atom-% verfügbar ist und
- Silicium im Bereich von 0,7-1,7 Atom-% verfügbar ist.

2. Schneidwerkzeug (1) nach Anspruch 1, wobei das Verhältnis des niedrigsten Siliciumgehalts C_{Si,L} zu dem höchsten Siliciumgehalt C_{Si,H} aus dem Bereich von 0,4≤C_{Si,L}/C_{Si,H}≤0,6 ausgewählt ist.

3. Schneidwerkzeug (1) nach einem der vorangehenden Ansprüche, wobei C_{Si,H} ≤ 1,7 und C_{Si,L} ≤ 1.

4. Schneidwerkzeug (1) nach einem der vorangehenden Ansprüche, wobei die Schichten (21) des ersten Schichtelements eine Dicke (215) der Schichten des ersten Schichtelements im Bereich von 0,1-0,5 µm aufweisen.

5. Schneidwerkzeug (1) nach einem der vorangehenden Ansprüche, wobei in jeder der Schichten (21) des ersten Schichtelements eine Kombination aus Titan und Chrom im Bereich von 21-27 Atom-%, bezogen auf eine Gesamtmenge der Metall- und der metallähnlichen Elemente, verfügbar ist.

6. Schneidwerkzeug (1) nach einem der vorangehenden Ansprüche, wobei die mehreren Schichten (21) des ersten Schichtelements eine Anzahl subs_{N} gestapelter Untergruppen (200) der Schichten (21) des ersten Schichtelements umfassen, wobei subs_{N} wenigstens 2 beträgt, und wobei jede der Untergruppen (200) die erste Art (22) der Schichten (22, 23) und die zweite Art (23) der Schichten (22, 23) umfasst, wobei eine Untergruppendicke (205) jeder der Untergruppen (200) gleich oder kleiner als 1 µm ist.

7. Schneidwerkzeug (1) nach Anspruch 6, wobei wenigstens eine der Untergruppen (200) der gestapelten Untergruppen (200) wenigstens drei unterschiedliche Arten von Schichten (21) des ersten Schichtelements umfasst.

8. Schneidwerkzeug (1) nach einem der vorangehenden Ansprüche, wobei eine Dicke (25) des ersten Schichtelements (20) aus dem Bereich von 2-7 µm ausgewählt ist.

9. Schneidwerkzeug (1) nach einem der vorangehenden Ansprüche, wobei die Beschichtung (10) ferner Folgendes umfasst: (i) ein Grundschichtelement (30), das zwischen dem Substrat (5) und dem ersten Schichtelement (20) angeordnet ist, und/oder (ii) ein Deckschichtelement (40), das über dem ersten Schichtelement (10) angeordnet ist, wobei eine Grundschichtelementdicke (35) des Grundschichtelements (30) aus dem Bereich von 0,2-1,2 µm ausgewählt ist, wobei das Grundschichtelement (30) eine oder mehrere Grundschichtelementschichten (31) umfasst, wobei jede der Grundschichtelementschichten (31) eine Nitridschicht umfasst, die Chromnitrid und/oder Aluminiumchromnitrid umfasst; und wobei eine Deckschichtelementdicke (45) des Deckschichtelements (40) aus dem Bereich von 0,2-1,2 µm ausgewählt ist, wobei das Deckschichtelement (40) eine oder mehrere Deckschichtelementschichten (41) umfasst, wobei jede der Deckschichtelementschichten (41) Folgendes umfasst: (i) eine Nitridschicht, die Chrom und/oder Aluminium umfasst, oder (ii) eine Carbonitridschicht, die Chrom und/oder Aluminium umfasst; und wobei eine Gesamtbeschichtungsdicke (15) der Beschichtung (10) aus dem Bereich von 3-8 µm ausgewählt ist.

10. Schneidwerkzeug (1) nach Anspruch 9, welches das Grundschichtelement (30) umfasst, wobei das Grundschichtelement (30) mehrere Grundschichtelementschichten (31) umfasst, wobei ein Aluminiumgehalt einer oberen Grundschichtelementschicht (319), die am nächsten an dem ersten Schichtelement (20) ausgebildet ist, höher ist als der Aluminiumgehalt in einer unteren Grundschichtelementschicht (311), die am nächsten an dem Substrat (5) ausgebildet ist.

11. Schneidwerkzeug (1) nach einem der vorangehenden Ansprüche, wobei das Schneidwerkzeug (1) ein Kreissägeblatt, ein Werkzeugaufsatz, ein Fräsaufsatz oder ein Bohrer ist.

12. Schneidwerkzeug (1) nach einem der vorangehenden Ansprüche, wobei das Substrat (5) einen unbeschichteten Bohraufsatz, ein unbeschichtetes Sägeblatt, einen unbeschichteten Zahn eines Sägeblatts, eine unbeschichtete Spitze eines Sägeblatts und/oder einen unbeschichteten Einsatz eines Sägeblatts umfasst.

13. Verfahren zur Herstellung eines Schneidwerkzeugs (1) mit einer Beschichtung (10) nach einem der Ansprüche 1-12 durch physikalische Gasphasenabscheidung, wobei das Verfahren Folgendes umfasst:
- Einbringen eines Substrats (5) in eine Vakuumkammer (150) eines Ofens (100) für physikalische Gasphasenabscheidung, wobei die Kammer (150) eine Anzahl Cat_{N} von Metallkathoden (110) umfasst, wobei Cat_{N} wenigstens 3 beträgt, wobei wenigstens eine Untergruppe der Anzahl Cat_{N} von Metallkathoden (110) zusammen die Metall- oder metallähnlichen Elemente Aluminium, Chrom, Titan und Silicium in einer Konzentration zum Bereitstellen des ersten Schichtelements umfasst, und
- Abscheiden der Beschichtung (10) auf dem Substrat (5) durch physikalische Gasphasenabscheidung, wobei (i) ein Stickstoff umfassendes gasförmiges Fluid und optional (ii) ein Kohlenstoff umfassendes gasförmiges Fluid (130) in der Vakuumkammer (150) bereitgestellt wird/werden, während das Substrat (5) gedreht wird, wobei die Beschichtung (10) Schicht für Schicht abgeschieden wird, um die Beschichtung (10) bereitzustellen, wobei ein Verdampfungsstrom zu einer Kathode (110), die Silicium umfasst, während des Abscheidens geändert wird und/oder wobei ein Strom zu einer Kathode (110), die kein Silicium umfasst, während des Abscheidens geändert wird, um die wenigstens zwei unterschiedlichen Arten von Schichten (22, 23) des ersten Schichtelements (20) mit einem unterschiedlichen Si-Gehalt bereitzustellen.

14. Verfahren nach einem der Ansprüche 13, wobei (i) wenigstens eine der Metallkathoden (110) die Metall- oder metallähnlichen Elemente Aluminium, Titan und Silicium umfasst und wobei wenigstens eine andere der Metallkathoden (110) die Metallelemente Aluminium und Chrom umfasst oder wobei (ii) wenigstens eine der Metallkathoden (110) die Metallelemente Aluminium, Chrom und Silicium umfasst und wobei wenigstens eine andere der Metallkathoden (110) die Metallelemente Aluminium und Titan umfasst und wobei während der Abscheidung den Metallkathoden (110) ein variabler Verdampfungsstrom zugeführt wird.

15. Verfahren nach einem der Ansprüche 13-14, wobei (i) eine erste Kathode eine AlCrSi-Kathode ist und eine zweite Kathode eine AlTi-Kathode ist oder (i) die erste Kathode eine AlTiSi-Kathode ist und die zweite Kathode eine AlCr-Kathode ist, wobei die Metallkathoden (110) wenigstens zwei zweite Kathoden pro erster Kathode umfassen, wobei das Substrat (5) um eine Mittelachse (160) der Vakuumkammer (150) gedreht wird, wobei die zweiten Kathoden auf gegenüberliegenden Seiten der Mittelachse (160) angeordnet sind und wobei die erste Kathode einer der zweiten Kathoden benachbart in einer Ebene parallel zu einer Wand des Ofens (100) für physikalische Gasphasenabscheidung angeordnet ist.

## Revendications

1. Outil de coupe (1) comprenant un revêtement (10) sur un substrat (5), le revêtement (10) comprenant un premier élément de couche (20), le premier élément de couche (20) ayant une composition globale comprenant les éléments métalliques ou métalloïdes aluminium, chrome, titane et silicium, les éléments métalliques ou métalloïdes aluminium, chrome, titane et silicium définissant au moins 99 % at. d'un total des éléments métalliques et métalloïdes dans le premier élément de couche (20), le premier élément de couche (20) comprenant un nombre N_{lay} de couches de premier élément de couche (21), N_{lay} étant au moins 2, chacune des couches de premier élément de couche (21) étant une couche de nitrure des éléments métalliques ou métalloïdes aluminium, chrome, titane et silicium, les couches de premier élément de couche N_{lay} (21) comprenant au moins deux types différents de couches (22, 23), les différents types de couches (22, 23) différant au moins par une teneur en silicium, un premier type (22) des couches (22, 23) ayant une teneur en silicium la plus élevée C_{Si,H} exprimée en % atomique, par rapport à l'ensemble des éléments métalliques et métalloïdes, et un deuxième type (23) de couches (22, 23) ayant une teneur en silicium la plus faible C_{Si,L} exprimée en % at., par rapport à l'ensemble des éléments métalliques et métalloïdes, un rapport entre la teneur en silicium la plus faible C_{Si,L} et la teneur en silicium la plus élevée C_{Si,H} étant choisi dans la plage de 0, 25≤C_{Si,L}/C_{Si,H}≤0, 9 ; une épaisseur (25) du premier élément de couche (20) étant choisie dans la plage de 1 à 12 um ; dans le premier élément de couche (20), par rapport à un total d'éléments métalliques et métalloïdes
- l'aluminium étant disponible dans la plage de 72-77 % at.,
- le titane étant disponible dans la plage de 5 à 11 % at.,
- le chrome étant disponible dans la plage de 13 à 20 % at., et
- le silicium étant disponible dans la plage de 0,7 à 1,7 % at..

2. Outil de coupe (1) selon la revendication 1, le rapport entre la teneur en silicium la plus faible C_{Si,L}, et la teneur en silicium la plus élevée C_{Si,H} étant choisi dans la plage de 0,4≤C_{Si,L}/C_{Si,H}≤0,6.

3. Outil de coupe (1) selon l'une quelconque des revendications précédentes, avec C_{Si,H}≤1,7 et C_{Si,L}≤1.

4. Outil de coupe (1) selon l'une quelconque des revendications précédentes, les couches de premier élément de couche (21) ayant une épaisseur de couche de premier élément de couche (215) dans la plage de 0,1 à 0,5 µm.

5. Outil de coupe (1) selon l'une quelconque des revendications précédentes, dans chacune des couches de premier élément de couche (21), une combinaison de titane et de chrome étant disponible dans la plage de 21 à 27 % at. par rapport à un total du métal et des éléments métalloïdes.

6. Outil de coupe (1) selon l'une quelconque des revendications précédentes, la pluralité de couches de premier élément de couche (21) comprenant un nombre subs_{N} de sous-ensembles empilés (200) de la couche de premier élément de couche (21), subs_{N} étant au moins 2, et chacun des sous-ensembles (200) comprenant le premier type (22) des couches (22, 23) et le deuxième type (23) des couches (22, 23), une épaisseur de sous-ensemble (205) de chacun des sous-ensembles (200) étant égale ou inférieure à 1 µm.

7. Outil de coupe (1) selon la revendication 6, au moins un des sous-ensembles (200) des sous-ensembles empilés (200) comprenant au moins trois types différents de couches de premier élément de couche (21).

8. Outil de coupe (1) selon l'une quelconque des revendications précédentes, une épaisseur (25) du premier élément de couche (20) étant choisie dans la plage de 2 à 7 µm.

9. Outil de coupe (1) selon l'une quelconque des revendications précédentes, le revêtement (10) comprenant en outre (i) un élément de couche de base (30) agencé entre le substrat (5) et le premier élément de couche (20) et/ou (ii) un élément de couche supérieure (40) agencé sur le premier élément de couche (10), une épaisseur (35) d'élément de couche de base de l'élément de couche de base (30) étant choisie dans la plage de 0,2 à 1,2 um, l'élément de couche de base (30) comprenant une ou plusieurs couches d'élément de couche de base (31), l'une quelconque des couches d'élément de couche de base (31) comprenant une couche de nitrure comprenant du nitrure de chrome et/ou du nitrure d'aluminium-chrome ; et une épaisseur d'élément de couche supérieure (45) de l'élément de couche supérieure (40) étant choisie dans la plage de 0,2 à 1,2 um, l'élément de couche supérieure (40) comprenant une ou plusieurs couches d'élément de couche supérieure (41), l'une quelconque des couches d'élément de couche supérieure (41) comprenant (i) une couche de nitrure comprenant du chrome et/ou de l'aluminium ou (ii) une couche de carbonitrure comprenant du chrome et/ou de l'aluminium ; et une épaisseur de revêtement totale (15) du revêtement (10) étant choisie dans la plage de 3 à 8 um.

10. Outil de coupe (1) selon la revendication 9, comprenant l'élément de couche de base (30), l'élément de couche de base (30) comprenant une pluralité de couches d'élément de couche de base (31), une teneur en aluminium d'une couche d'élément de couche de base supérieure (319) configurée le plus près du premier élément de couche (20) étant plus élevée que la teneur en aluminium dans une couche d'élément de couche de base inférieure (311) configurée le plus près du substrat (5).

11. Outil de coupe (1) selon l'une quelconque des revendications précédentes, l'outil de coupe (1) étant une lame de scie circulaire, une mèche d'outil, une fraise à défoncer ou une perceuse.

12. Outil de coupe (1) selon l'une quelconque des revendications précédentes, le substrat (5) comprenant un ou plusieurs éléments parmi une mèche non revêtue, une lame de scie non revêtue, une dent non revêtue d'une lame de scie, une pointe non revêtue d'une lame de scie, et un insert non revêtue d'une lame de scie.

13. Procédé de fabrication d'un outil de coupe (1) comprenant un revêtement (10) selon l'une quelconque des revendications 1 à 12, par dépôt physique en phase vapeur, le procédé comprenant :
- la fourniture d'un substrat (5) dans une chambre à vide (150) d'un four de dépôt physique en phase vapeur (100), la chambre (150) comprenant un nombre Cat_{N} de cathodes métalliques (110), Cat_{N} étant au moins 3, au moins un sous-ensemble du nombre Cat_{N} de cathodes métalliques (110) comprenant les éléments métalliques ou métalloïdes aluminium, chrome, titane et silicium dans une concentration permettant d'obtenir le premier élément de couche, et
- le dépôt du revêtement (10) sur le substrat (5) par dépôt physique en phase vapeur, (i) d'un fluide gazeux contenant de l'azote et éventuellement (ii) d'un fluide gazeux contenant du carbone (130) étant fourni dans la chambre à vide (150), tout en faisant tourner le substrat (5), le revêtement (10) étant déposé couche par couche, afin de fournir le revêtement (10), un courant d'évaporation vers une cathode (110) comprenant du silicium étant modifié pendant le dépôt et/ou un courant vers une cathode (110) ne comprenant pas de silicium étant modifié pendant le dépôt, afin de fournir l'au moins deux types différents de couches (22, 23) du premier élément de couche (20) avec une teneur en silicium différente.

14. Procédé selon l'une quelconque des revendications 13, (i) au moins une des cathodes métalliques (110) comprenant les éléments métalliques ou métalloïdes aluminium, titane et silicium, et au moins une autre des cathodes métalliques (110) comprenant les éléments métalliques aluminium et chrome ou (ii) au moins une des cathodes métalliques (110) comprenant les éléments métalliques aluminium, chrome et silicium, et au moins une autre des cathodes métalliques (110) comprenant les éléments métalliques aluminium et titane, et, pendant le dépôt, un courant d'évaporation variable étant fourni aux cathodes métalliques (110).

15. Procédé selon l'une quelconque des revendications 13 et 14, (i) une première cathode étant une cathode AlCrSi et une deuxième cathode étant une cathode AlTi ou (i) la première cathode étant une cathode AlTiSi et la deuxième cathode étant une cathode AlCr, les cathodes métalliques (110) comprenant au moins deux deuxièmes cathodes par première cathode, le substrat (5) étant tourné autour d'un axe central (160) de la chambre à vide (150), les deuxièmes cathodes étant agencées sur les côtés opposés de l'axe central (160), et la première cathode étant agencée de manière adjacente à l'une des deuxièmes cathodes dans un plan parallèle à une paroi du four de dépôt physique en phase vapeur (100).
